# EUROPEAN PATENT SPECIFICATION

(11) **EP 3 043 415 B1**
(45) Date of publication and mention of the grant of the patent: **01.11.2017**
(21) Application number: 14898855.3
(22) Date of filing: 31.07.2014
(51) Int. Cl.: H01M 10/48, G01R 31/36, H01M 10/42, G01R 1/04, G01R 3/00

(54) **SHEET-LIKE-BATTERY TEST DEVICE AND SHEET-LIKE-BATTERY TEST METHOD**
FOLIENBATTERIEN-TESTVORRICHTUNG UND FOLIENBATTERIEN-TESTVERFAHREN
DISPOSITIF D'ESSAI DE BATTERIE EN FEUILLE ET PROCÉDÉ D'ESSAI DE BATTERIE EN FEUILLE

(43) Date of publication of application: 13.07.2016
(73) Proprietor: Kabushiki Kaisha Nihon Micronics, Musashino-shi, Tokyo 180-8508 (JP)
(72) Inventor: SAITO, Tomokazu, Musashino-shi Tokyo 180-8508 (JP); TSUNOKUNI, Kazuyuki, Musashino-shi Tokyo 180-8508 (JP); HIWADA, Kiyoyasu, Musashino-shi Tokyo 180-8508 (JP)
(74) Representative: Grünecker Patent- und Rechtsanwälte PartG mbB
(86) International application number: PCT/JP2014/070247
(87) International publication number: WO 2016/017008

(56) References cited:
- WO-A1-2013/035149
- WO-A1-2013/161926
- CA-A1- 2 848 164
- CA-A1- 2 870 807
- JP-A- 2001 160 393

## Description

### TECHNICAL FIELD

The present invention relates to a testing device and a testing method for a sheet-shaped cell, and for example, relates to a testing device and a testing method for a sheet-shaped secondary cell.

### BACKGROUND ART

Some cells are sheet-shaped as a basic structure thereof. In a manufacturing process of such a sheet-shaped cell having the basic structure (hereinafter, simply called a sheet-shaped cell as well), it is performed to test performance and the like of a sheet-shaped cell during manufacturing or after completion.

In this specification, "a sheet-shaped cell" denotes a thin-plate-shaped (sheet-shaped) cell that includes at least electrode layers (a positive electrode layer and a negative electrode layer) and an inter-electrode layer interposed between the electrode layers. The electrode layers and the inter-electrode layer may be layered plurally in the thickness direction or arranged plurally in the expansion direction. The inter-electrode layer prevents contacting between both the electrodes and contributes to electromotive force generation and electricity storage. For example, the inter-electrode layer may be an electrolyte, a separator, a charging-discharging layer (charging layer), or the like. Here, "test" denotes a term that includes "evaluation", "examination", and "measurement". Further, "cell test" denotes a concept that includes cell performance check, a charging-discharging test, conditioning, a charging-discharging cycle test, an aging test, and the like.

As a testing method for a sheet-shaped cell, there is a method to examine a wound electrode body to be used for a non-aqueous electrolyte secondary cell, for example, as disclosed in Patent Document 1. The wound electrode body being an examination object is formed by winding a positive electrode material and a negative electrode material that are belt-shaped along with a first separator material and a second separator material that are belt-shaped. There is disclosed a technology to convey a plurality of wound electrode bodies one by one to a test position with a belt conveyor for conveying and to test sequentially.

Further, for example, being related to an examining method of an electrode plate that structures a sheet-shaped cell, Patent Document 2 discloses a method to determine a malfunction that causes internal short circuit of an electrode plate for a secondary cell. The electrode plate being an examination object includes a porous insulation layer that is formed on a surface of an electrode plate being a positive electrode plate or a negative electrode plate. Then, current is continuously measured while the electrode plate attached with the porous insulation layer is caused by an electrode plate unwinding/winding roll to travel and voltage is applied thereto by a pair of examination electrodes arranged at a midpoint of the travelling.

Further, as a testing device for a cell, for example, Patent Document 3 discloses a charging-discharging device that performs charging-discharging operations concurrently in parallel on a plurality of secondary cells. Here, it is disclosed an example in which the charging-discharging device is applied for a conditioning test of a secondary cell.

Recently, an all-solid-state secondary cell structured by solid-thinning has been researched and developed and has been expected to be a miniaturized secondary cell. As one of such secondary cells, Patent Document 4 discloses a secondary cell based on an operational principle of forming a new energy level in a band gap and capturing an electron by utilizing a photoexcited structural change of a metal oxide semiconductor. In the cell, a charging layer to which insulation-coated n-type metal oxide semiconductor particles are filled is arranged between a first electrode and a second electrode. According to the charging layer, new energy level is formed in a band gap of the n-type metal oxide semiconductor based on a photoexcited structural change phenomenon with ultraviolet irradiation and energy is charged by capturing electrons at the energy level. In this specification, an all-solid-state physical secondary cell utilizing a photoexcited structural change of a metal oxide is denoted as a quantum cell.

### CITED DOCUMENT

### PATENT DOCUMENT

Patent Document 1: Japanese Patent Application Laid-open No. 2004-273216
Patent Document 2: Japanese Patent Application Laid-open No. 2010-40362
Patent Document 3: International Patent Application Laid-open No. 2014/017463
Patent Document 4: International Patent Application Laid-open No. 2013/065093

### SUMMARY OF THE INVENTION

Here, according to the conventional testing device for a cell disclosed in Patent Document 1, a conveying device such as a belt conveyor is required for a non-tested object to be conveyed to a test position or to be discharged from the test position. Accordingly, a size of the entire testing device becomes large and large test space is required.

Further, since the testing device includes only one pair of terminals for supplying power for testing, there has been a problem that testing takes time as being required to be sequentially performed one by one.

In consideration to the above, it is considerable to shorten processing time by arranging a plurality of test terminals to be capable of performing testing concurrently at a plurality of positions. However, in this case, it is required to arrange a plurality of testing devices and test positions along the flow direction of the belt conveyor to cause travel distance of the belt conveyor to be elongated by the amount thereof. Accordingly, it is anticipated that the size of the testing device and space required for the testing become larger.

Further, it is considerable that testing as arranging test electrodes on a midpoint of drawing travel of a roll-shaped sheet-shaped member as a technology disclosed in Patent Document 2 is applied to examination of a sheet-shaped cell. However, in this case as well, when a plurality of test terminals are arranged to be capable of performing testing concurrently at a plurality of positions, it is required to arrange a plurality of testing devices and test positions along the travel direction of the drawn roll to cause travel distance of the drawn roll to be prolonged by the amount thereof. Accordingly, it is anticipated that the size of the testing device and space required for the testing become larger.

Considering the above, there have been desired a testing device for a sheet-shaped cell and a testing method for a sheet-shaped cell with which test space can be saved by lessening a size of the testing device for a cell and test time can be shortened by performing testing concurrently at a plurality of segments.

To solve such problems, according to a first aspect of the present invention, a testing device for a sheet-shaped cell includes a folding unit that folds a sheet-shaped cell having electrode layers on both faces while alternately changing a folding direction, and a testing unit that performs a predetermined test as supplying power to electrode terminals in a state that the electrode terminals are inserted respectively to folded portions of the sheet-shaped cell.

According to a second aspect of the present invention, a testing method for a sheet-shaped cell includes steps of folding a sheet-shaped cell having electrode layers on both faces while alternately changing a folding direction and testing to perform a predetermined test as supplying power to electrode terminals in a state that the electrode terminals are inserted respectively to folded portions of the sheet-shaped cell.

According to the present invention, since the sheet-shaped cell is alternately folded and the electrode terminals are inserted to gaps at the folded sheet-shaped cell, test space can be saved by lessening a size of the testing device for a cell. Further, handling can be facilitated for conveying the sheet-shaped cell being a test object to a testing step or discharging to a subsequent step. Further, since the sheet-shaped cell can be tested concurrently at a plurality of segments, test time can be shortened.

### BRIEF DESCRIPTION OF THE DRAWINGS

FIG. 1 is a structural view illustrating a general structure of a testing device according to a first embodiment.
FIG. 2 is a first view illustrating a sheet-shaped quantum cell according to the first embodiment.
FIG. 3 is a second view illustrating the sheet-shaped quantum cell according to the first embodiment.
FIG. 4 is a view illustrating a connection relation between a folded sheet-shaped cell and a cell tester according to the first embodiment.
FIG. 5 is an explanatory view of a structure of a positive electrode terminal plate according to the first embodiment.
FIG. 6 is a view illustrating a first shape of a conductive material on a surface of an electrode terminal plate according to an embodiment.
FIG. 7 is a view illustrating a second shape of a conductive material on a surface of an electrode terminal plate according to an embodiment.
FIG. 8 is a view illustrating a third shape of a conductive material on a surface of an electrode terminal plate according to an embodiment.
FIG. 9 is a view illustrating a fourth shape of a conductive material on a surface of an electrode terminal plate according to an embodiment.
FIG. 10 is an explanatory view of a structure of a negative electrode terminal plate according to the first embodiment.
FIG. 11 is a sectional view illustrating a connection relation between the folded sheet-shaped cell and the electrode terminal plates according to the first embodiment.
FIG. 12 is an explanatory view of an example of a folding operation of a sheet folding mechanism portion 122 according to the first embodiment.
FIG. 13 is a first view illustrating a sheet-shaped cell according to a second embodiment.
FIG. 14 is a second view illustrating the sheet-shaped cell according to the second embodiment.
FIG. 15 is a structural view illustrating a general structure of a testing device according to the second embodiment.
FIG. 16 is a sectional view illustrating a connection relation between the folded sheet-shaped cell and the electrode terminal plates according to the second embodiment.
FIG. 17 is an explanatory view of an operation of a sheet folding mechanism portion according to the second embodiment.
FIG. 18 is a first view illustrating a sheet-shaped cell according to a third embodiment.
FIG. 19 is a second view illustrating the sheet-shaped cell according to the third embodiment.
FIG. 20 is a structural view illustrating a general structure of a testing device according to the third embodiment.
FIG. 21 is a first view illustrating a connection relation between a folded sheet-shaped cell and a cell tester according to the third embodiment.
FIG. 22 is a second view illustrating a connection relation between the folded sheet-shaped cell and the cell tester according to the third embodiment.
FIG. 23 is a first view illustrating a sheet-shaped cell according to a fourth embodiment.
FIG. 24 is a second view illustrating the sheet-shaped cell according to the fourth embodiment.
FIG. 25 is a view illustrating a connection relation between a folded sheet-shaped cell and a cell tester according to the fourth embodiment.

### EMBODIMENTS OF THE INVENTION

### (A) First embodiment

In the following, a first embodiment of a sheet-shaped cell testing device and a sheet-shaped cell testing method according to the present invention will be described in detail with reference to the drawings.

Here, types of sheet-shaped cells are not specifically limited as long as having a basic structure of a sheet-shaped cell that includes electrode layers (a positive electrode layer and a negative electrode layer) and an inter-electrode layer interposed between the electrode layers. For example, it is possible to be applied widely to a first cell and a secondary cell of a chemical battery and a physical battery. It is preferable to be applied to an all-solid-state secondary cell and more preferable to be applied to a quantum cell. The inter-electrode layer is a portion that contributes to electromotive force generation and electricity storage while preventing contact between both the electrodes. For example, the inter-electrode layer may be an electrolyte, a separator, a charging-discharging layer or the like, preferably, a charging-discharging layer of a secondary cell, and more preferably, a charging-discharging layer of a quantum cell.

Further, the cell testing device can be widely applied to a device that tests cell performance such as performance check, a charging-discharging test, conditioning, a charging-discharging cycle test, and an aging test.

### (A-1) Quantum cell

Here, the embodiment exemplifies a case that a sheet-shaped cell is a quantum cell. Firstly, description will be provided on a basic structure of a quantum cell.

A quantum cell is a secondary cell based on an operational principle of forming a new energy level in a band gap and capturing an electron by utilizing a photoexcited structural change of a metal oxide.

The quantum cell is an all-solid-state secondary cell. The structure solely functioning as a secondary cell includes a solid charging-discharging layer (in this specification, simply called a charging layer as well) between a negative electrode layer and a positive electrode layer.

The charging layer is a layer to store electrons with charge operation, to release the charging electrons with discharging operation, and to keep the electrons (perform storage of electricity) in a state without charging-discharging. The charging layer is formed by applying a photoexcited structural change technology.

The photoexcited structural change is described, for example, in International Patent Application Laid-open No. WO/2008/053561 and is a phenomenon (technology) found by Akira Nakazawa, who is an inventor of the above application. That is, Akira Nakazawa found out that, when effective excitation energy is applied to an insulation-coated translucent metal oxide which is a semiconductor having a band gap at a predetermined value or higher, a number of energy levels with no electron are generated in the band gap. The quantum cell is charged by being caused to capture electrons in these energy levels and discharged by being caused to release the captured electrons.

The charging layer is formed in a way where insulation-coated n-type metal oxide semiconductor particles adhere to the negative electrode layer 3 in a thin film shape and is transformed to be capable of storing electrons with a photoexcited structural change caused at the n-type metal oxide semiconductor by ultraviolet irradiation.

The positive electrode layer includes a positive electrode main body layer and a p-type metal oxide semiconductor layer formed to be in contact with the charging layer. The p-type metal oxide semiconductor layer is arranged so that electrons are prevented from being injected from the electrode main body layer to the charging layer.

The negative electrode layer and the electrode main body layer of the positive electrode layer are simply required to be formed as conductive layers.

The quantum cell having the above-mentioned basic structure can be arranged as a battery by attaching electrode terminals to the electrode layers as required and attaching an exterior member, a covering member, and the like to the outer side. Further, a plurality of the basic structures of the quantum cell can be packaged by being layered and connected in series or in parallel.

### (A-2) Sheet-shaped quantum cell

A sheet-shaped cell being a test object in the embodiment will be described as a case of a sheet-shaped quantum cell having the above-mentioned basic structure. In the following, the sheet-shaped quantum cell will be described with reference to the drawings.

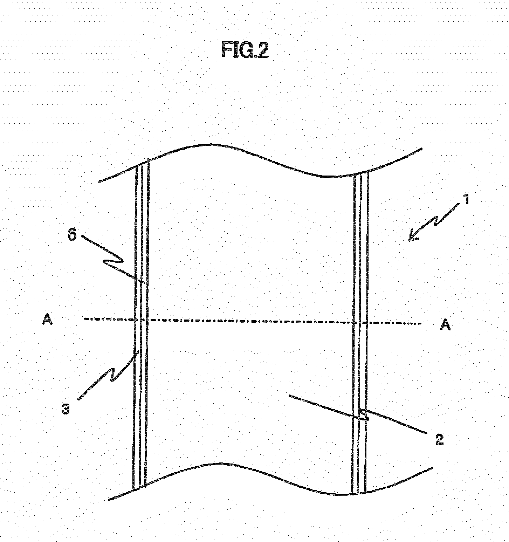

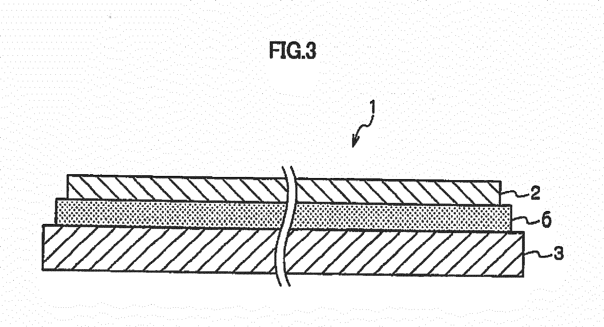

FIGs. 2 and 3 illustrate a sheet-shaped quantum cell 1 (hereinafter, simply called a sheet-shaped cell 1 as well) according to the embodiment. FIG. 2 is a front view of the sheet-shaped cell 1 and FIG. 3 is a sectional view of the sheet-shaped cell 1 at line A-A in FIG. 2.

As illustrated in FIGs. 2 and 3, the sheet-shaped cell 1 according to the embodiment has an elongated thin-plate shape having the basic structure in which a negative electrode layer 3, a charging layer 6, and a positive electrode layer 2 are layered in the order thereof. The positive electrode layer 2 includes a p-type metal oxide semiconductor layer formed on the charging layer 6 and a positive electrode main body layer layered thereon. The positive electrode main body layer and the negative electrode layer 3 are simply required to be formed as conductive layers. For example, a metal plate, a metal film, a translucent conductive film, and the like may be adopted.

As illustrated in FIG. 2, both side edges in a longitudinal direction of the sheet-shaped cell 1 are formed in parallel to each other. Width of the sheet-shaped cell 1 is not limited particularly. For example the width may be approximately in a range between 10 mm and 500 mm. Length of the sheet-shaped quantum cell 1 is not limited particularly as long as being equal to or longer than a length that enables to be folded and superposed at least one time. For example, the length may be approximately in a range between 10 mm and 100 mm.

Thickness of the positive electrode layer 2 and the negative electrode layer 3 may be approximately in a range between 10 nm and 1 µm and thickness of the charging layer 6 may be approximately in a range between 50 nm and 10 µm. The sheet-shaped cell 1 may be formed to have flexibility so as to be capable of being wound into a roll shape after being manufactured.

### (A-3) Structure of first embodiment

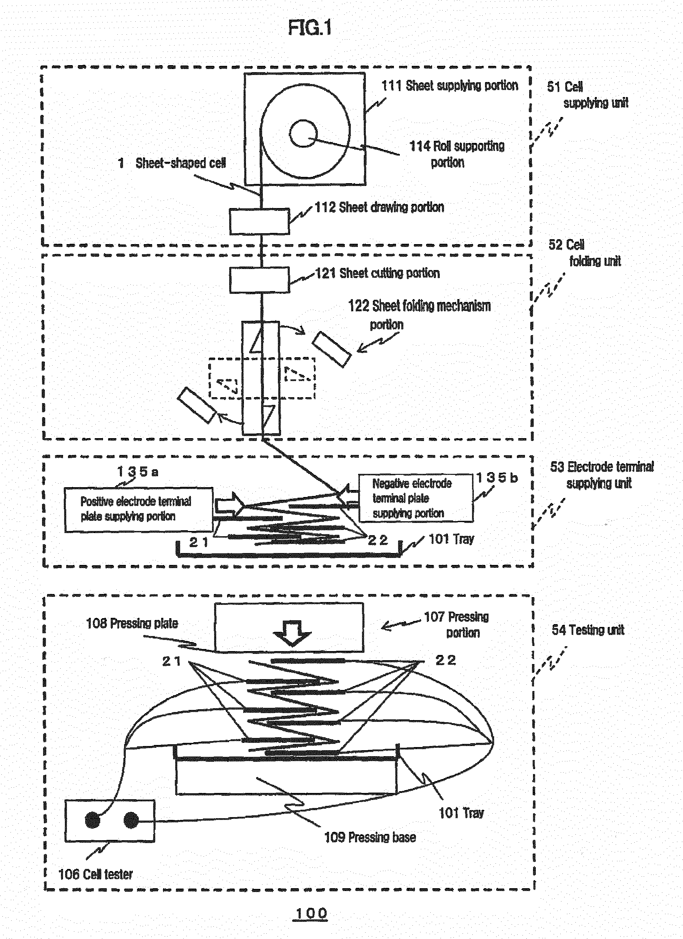

FIG. 1 is an explanatory view of a general flow of a testing method and a testing device for a cell according to the first embodiment.

As illustrated in FIG. 1, the testing method and the testing device 100 for a cell according to the first embodiment are roughly divided into a cell supplying unit (cell supplying step) 51 that supplies the sheet-shaped cell 1, a cell folding unit (cell folding step) 52 that folds the sheet-shaped cell 1 supplied from the cell supplying unit 51, an electrode terminal supplying unit (electrode terminal supplying step) 53 that supplies an electrode terminal into the sheet-shaped cell 1 folded by the cell folding unit 52, and a testing unit (testing step) 54 that tests the sheet-shaped cell 1 into which the electrode terminal is supplied by the electrode terminal supplying unit 53.

The testing unit 54 performs testing of the sheet-shaped cell 1. For example, the testing unit 54 performs cell performance check, a charging-discharging test, conditioning, a charging-discharging cycle test, an aging test, and the like. The testing unit 54 includes a cell tester 106 and a pressing portion 107.

The cell tester 106 performs power supplying and electrical characteristic measuring required for performing testing such as cell performance check, a charging-discharging test, conditioning, a charging-discharging cycle test, and an aging test on the sheet-shaped cell 1 folded by the cell folding unit 52 into an accordion shape (hereinafter, the sheet-shaped cell folded into an accordion shape is called an accordion-shaped cell as well) using a positive electrode terminal plate 21 and a negative electrode terminal plate 22 for electrical connection arranged therein and on upper and lower faces.

The pressing portion 107 applies pressure on the accordion-shaped cell 1 as sandwiching from both outer faces in a state that the positive electrode terminal plate 21 and the negative electrode terminal plate 22 are arranged at the folded portion and the upper and lower faces. Pressure applied on the sheet-shaped cell 1 by the pressing portion 107 can provide reliable contact of the electrode layers 2, 3 of the sheet-shaped cell 1 with the positive electrode terminal plate 21 and the negative electrode terminal plate 22 that are sandwiched between folded portions or arranged on the upper and lower faces of the accordion-shaped cell 1. In the embodiment, the pressing portion 107 includes a pressing base 109 on which the folded sheet-shaped cell 1 is placed, a pressing plate 108 that presses the sheet-shaped cell 1 placed on the pressing base 109 from the upper side to the lower side, and an unillustrated pressing mechanism portion that moves the pressing plate 108 in the pressing direction.

The pressing plate 108 has a plate shape to apply pressure to the accordion-shaped cell 1, for example from the upper side to the lower side. The pressing plate 108 has a flat pressing face capable of performing pressing. The pressing plate 108 presses an upper face of the accordion-shaped cell 1 as being moved downward by the pressing mechanism portion from the upper side of the sheet-shaped cell 1 toward the pressing base 109 while the pressing face is kept approximately horizontal. Here, to provide excellent contact of the sheet-shaped cell 1 with the positive electrode terminal plate 21 and the negative electrode terminal plate 22, the pressing plate 108 may have a pressing face that presses the entire upper face of the accordion-shaped cell 1. However, it is also possible that the pressing plate 108 has a pressing face that presses at least a region where conductive portions of the positive electrode terminal plate 21 and the negative electrode terminal plate 22 make contact with the electrode layers 2, 3 of the accordion-shaped cell 1 (that is, a partial region of the upper face of the sheet-shaped cell 1).

The pressing mechanism portion causes the pressing plate 108 to be capable of pressing the upper face of the folded sheet-shaped cell 1 with predetermined pressure. The pressing mechanism portion includes a mechanism to vertically move the pressing plate 108, so that the pressing plate 108 is moved downward while the pressing face thereof is kept horizontal as facing downward to be capable of maintaining a pressing state at the predetermined pressure.

The pressing base 109 is arranged below the pressing plate 108 in the pressing direction so that the accordion-shaped cell 1 is placed thereon. The pressing base 109 has a flat placement face that is opposed to the pressing face of the pressing plate 108. The pressing base 109 supports, from the lower face, the sheet-shaped cell 1 on the placement face to be pressed by the pressing plate 108. The placement face may support the entire lower face of the accordion-shaped cell 1. However, it is also possible that the placement face supports at least a region where conductive portions of the positive electrode terminal plate 21 and the negative electrode terminal plate 22 make contact with the electrode layers of the accordion-shaped sheet-shaped cell 1 (that is, a partial region of the lower face of the sheet-shaped cell 1). According to the above, pressure can be applied with the folded sheet-shaped cell 1 sandwiched by the pressing plate 108 and the pressing base 109.

Here, the folded sheet-shaped cell 1 to be pressed by the pressing portion 107 may be placed directly on the placement face of the pressing base 109 or may be placed thereon in a state of being placed on a tray 101 as described later.

Further, the embodiment exemplifies a case that pressing is performed while the pressing plate 108 is moved from the upper side to the lower side in a state that the pressing base 109 is fixed. However, it is not limited thereto. That is, as long as being capable of applying pressure while sandwiching the folded sheet-shaped cell 1 from both the faces, it is also possible, for example, that pressing is performed while the pressing base 109 is pressed up from the lower side to the upper side with the pressing plate 108 fixed. Further, for example, it is also possible that the pressing base 109 and the pressing plate 108 are movable and the pressing plate 108 is moved from the upper side to the lower side while the pressing base 109 is moved from the lower side to the upper side.

Further, the embodiment exemplifies a case that the pressing plate 108 is moved downward while the pressing face thereof is kept horizontal. However, not limited thereto, it is also possible, for example, that the pressing mechanism portion causes the pressing plate 108 to be capable of rotating. That is, it is also possible that the sheet-shaped cell 1 is pressed owing to that the pressing plate 108 is set at predetermined height and rotated from a state that the pressing face is vertical or inclined to a horizontal position after the sheet-shaped cell 1 is placed on the pressing base 109.

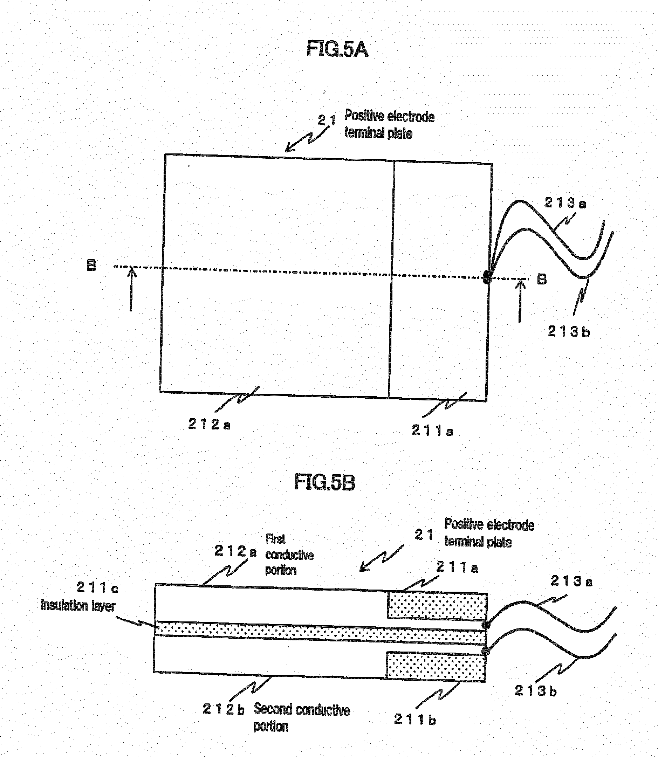

FIG. 5 is an explanatory view of a structure of the positive electrode terminal plate 21 according to the first embodiment. FIG. 5 (A) is a plane view of the positive electrode terminal plate 21 and FIG. 5 (B) is a sectional view at line B-B in FIG. 5(A).

As illustrated in FIG. 5, the positive electrode terminal plate 21 is formed by layering the conductive portions 212a, 212b made of a conductive material on both faces of an insulation layer 211c made of an insulating material. That is, the positive electrode terminal plate 21 has a structure that the insulation layer 211c is sandwiched by the first conductive portion 212a and the second conductive portion 212b. Thus, the first conductive portion 212a and the second conductive portion 212b are insulated from each other by the insulation layer 211c. Wires 213a, 213b are connected to end parts of the conductive portions 212a, 212b, respectively. Since there is a possibility that the end parts of the conductive portions 212a, 212b (in this example, the end parts where the wires 213a, 213b are connected) are protruded from folded portions when being sandwiched by the sheet-shaped cell 1, insulation layers 211a, 211c are formed on surfaces thereof. Thus, short circuit can be prevented from occurring during testing. The wires 213a, 213b are connected to positive electrode side terminals 105a of the cell tester 106.

In the above, the conductive portions 212a, 212b of the positive electrode terminal plate 21 function at entire faces thereof for electrical contact. However, partial or multipoint electrical contact may be adopted as well.

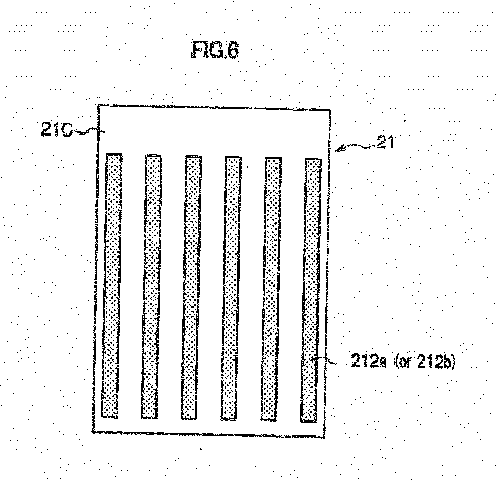

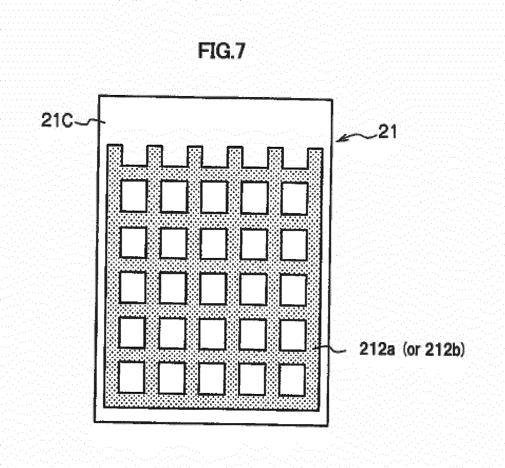

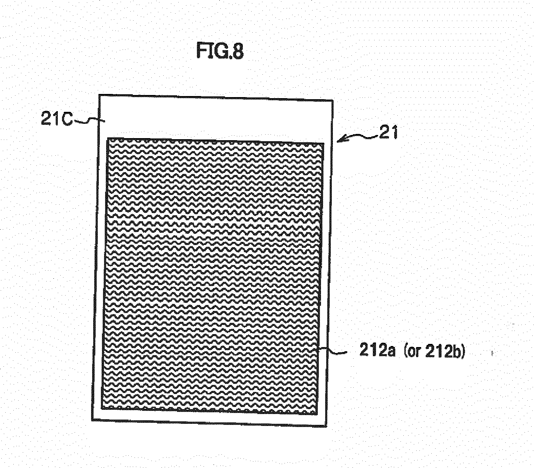

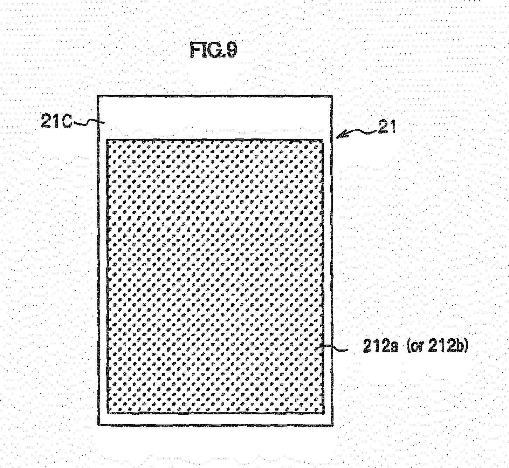

For example, as exemplified in FIG. 6, the conductive portions 212a, 212b of the positive electrode terminal plate 21 may be formed by arranging a conductive material in a stripes shape on the surface of the positive electrode terminal plate 21. Alternatively, for example, as exemplified in FIG. 7, a conductive material may be arranged in a lattice shape on the surface of the positive electrode terminal plate 21. Alternatively, for example, as exemplified in FIG. 8, a plurality of wave-shaped conductive materials may be arranged on the surface of the positive electrode terminal plate 21. Alternatively, as exemplified in FIG. 9, an emboss-shaped conductive material may be arranged on the surface of the positive electrode terminal plate 21. Here, shapes of the conductive portions 212a, 212b on the surface of the positive electrode terminal plate 21 are not limited to those exemplified in FIGs. 6 to 9. Alternatively, the conductive portions 212a, 212b may be formed in a comb-shape, a mesh-shape, or the like.

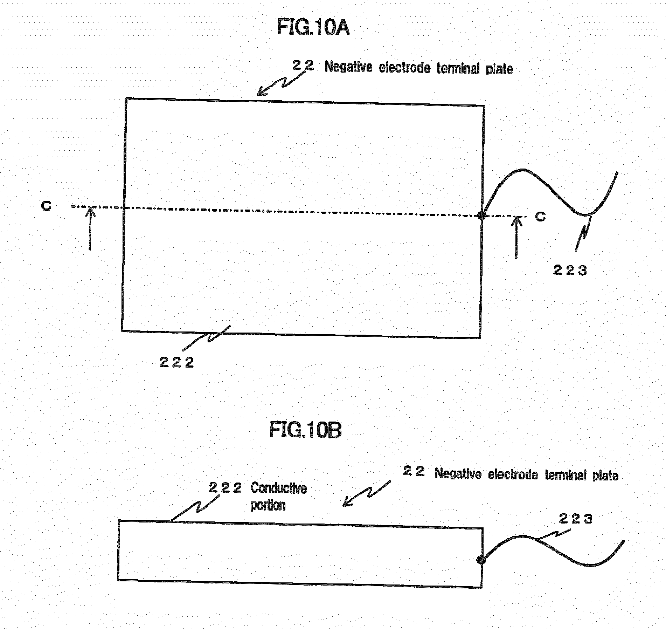

FIG. 10 is an explanatory view of a structure of the negative electrode terminal plate 22 according to the first embodiment. FIG. 10 (A) is a plane view of the negative electrode terminal plate 22 and FIG. 10 (B) is a sectional view at line C-C in FIG. 10(A).

As illustrated in FIG. 10, the negative electrode terminal plate 22 includes a conductive portion 222 made of a plate-shaped conductive material and a wire 223 is connected to an end part thereof. The wire 223 is connected to a negative electrode terminal 105b of the cell tester 106.

In the above, the conductive portion 222 of the negative electrode terminal plate 22 functions at entire faces thereof for electrical contact. However, partial or multipoint electrical contact may be adopted as well.

For example, similarly to the case of the positive electrode terminal plate 21 illustrated in FIGs. 6 to 9, the conductive portion 222 may be formed by arranging a conductive material in a stripes shape, a lattice shape, a plural-wave-shape, or an emboss shape on the surface of the negative electrode terminal plate 22. Alternatively, the conductive portion 222 may be formed by arranging a conductive material in a comb-shape, a mesh-shape, or the like.

The shape and material of the positive electrode terminal plate 21 are not limited, provided that the positive electrode layer 2 and the positive electrode connection terminal 105a of the cell tester 106 can be connected through the conductive portions 212a, 212b with a sufficiently low electrical resistance value. Similarly, the shape and material of the negative electrode terminal plate 22 are not limited, provided that the negative electrode layer 3 and the negative electrode connection terminal 105b of the cell tester 106 can be connected through the conductive portion 222 with a sufficiently low electrical resistance value. In the abovementioned example, since one test segment is shaped rectangular, it is preferable that front view shapes of the positive electrode terminal plate 21 and the negative electrode terminal plate 22 are rectangular for wide contact therewith.

For convenience of explanation, the positive electrode terminal plate 21 and the negative electrode terminal plate 22 are described as "plates". However, not limited to thin plates, the positive electrode terminal plate 21 and the negative electrode terminal plate 22 may be thin-film-shaped. Alternatively, the positive electrode terminal plate 21 and the negative electrode terminal plate 22 may be line-shaped or rod-shaped.

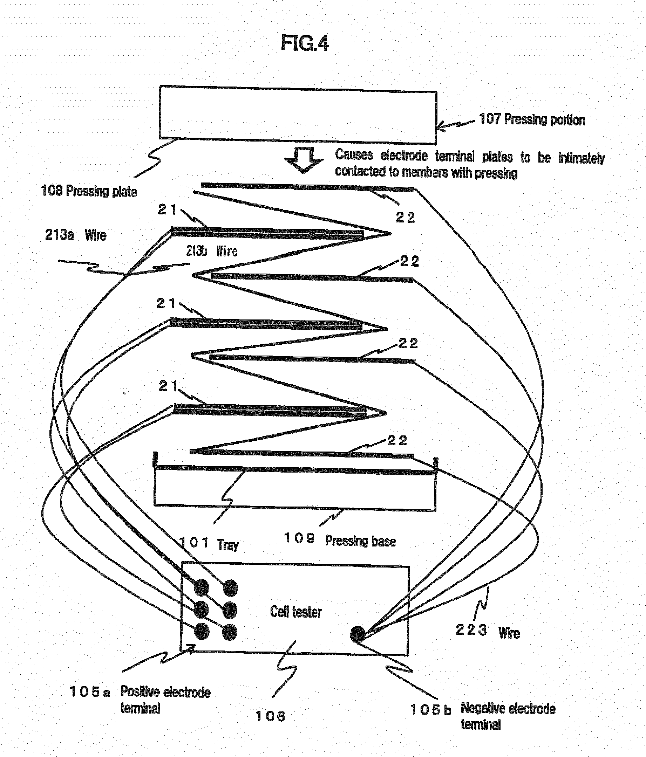

FIG. 4 is a view illustrating a connection relation between the folded sheet-shaped cell 1 and the cell tester 106 according to the first embodiment. In FIG. 4, the sheet-shaped cell 1 is illustrated in a state that the positive electrode terminal plate 21 and the negative electrode terminal plate 22 for electrical connection are inserted thereto. Further, FIG. 4 illustrates a connection relation of the cell tester 106 with the positive electrode terminal plate 21 and the negative electrode terminal plate 22 that are contacted to the sheet-shaped cell 1.

As illustrated in FIG. 4, the sheet-shaped cell 1 folded by the cell folding unit 52 is formed in an accordion shape. Here, the electrode terminal plates 21, 22 are inserted to gaps formed at inwardly-folded portions, respectively. Further, the negative electrode terminal plate 22 is arranged at each of the upper and lower faces of the folded sheet-shaped cell 1.

The positive electrode terminal plate 21 is inserted as a positive electrode terminal to a portion of the sheet-shaped cell 1 folded with the positive electrode layer 2 located at the inner side. Further, the negative electrode terminal plate 22 is inserted as a negative electrode terminal to a portion of the sheet-shaped cell 1 folded with the negative electrode layer 3 located at the inner side. That is, at the folded portions of the accordion-shaped cell 1, the positive electrode terminal plate 21 and the negative electrode terminal plate 22 are to be in contact with the sheet-shaped cell 1 alternately.

The cell tester 106 supplies power for testing (for example, applies voltage or flows current) as connecting the positive electrode terminal plate 21 and the negative electrode terminal plate 22 that are in contact with the accordion-shaped cell 1 to the connection terminals 105a, 105b as electrode terminals for electrical connection. The positive electrode terminal plate 21 is connected to the positive electrode terminal 105a of the cell tester 106 through the wires 213a, 213b. Further, the negative electrode terminal plate 22 is connected to the negative electrode terminal 105b of the cell tester 106 through the wire 223.

Here, in addition to a function to apply voltage or to flow current between the positive electrode terminal plate 21 and the negative electrode terminal plate 22, the cell tester 106 may have a function to measure electrical characteristics such as current and voltage between the positive electrode terminal plate 21 and the negative electrode terminal plate 22. The cell tester 106 may have a function to determine whether or not the measured electrical characteristics are within a previously-registered allowable range and to determine whether a cell at a measurement section is normal or abnormal. The abnormal section (test segment) is determined by specifying the positive electrode terminal plate 21 and the negative electrode terminal plate 22 or the conductive portions 212a, 212b of the positive electrode terminal plate 21 where the measurement value determined as being abnormal is measured.

Here, in a case that a sheet portion between adjacent fold lines of the folded sheet-shaped cell or a sheet portion between an end side and an adjacent fold line of the sheet-shaped cell 1 is considered as one test segment, the cell tester 106 can perform testing on a plurality of test segments currently in parallel. Further, since the cell tester 106 can perform testing on a plurality of test segments in parallel, when a malfunction occurs at any test segment among the plurality of test segments that are being concurrently tested, the cell tester 106 can separately discontinue power supplying to the malfunction-occurring test segment. In other words, since testing of a test segment without having a malfunction can be continued, test efficiency can be improved.

After the test is completed, the electrode terminal plates 21, 22 are removed from the sheet-shaped cell 1 and the sheet-shaped cell 1 is conveyed to the next step or stored as being maintained in an accordion shape. Here, a cell at a section where abnormality is detected in the testing step (for example, a test segment sandwiched by the positive electrode terminal plate 21 and the negative electrode terminal plate 22 where abnormality is detected) can be repaired or removed in a subsequent step.

Here, as illustrated in FIG. 4, since the sheet-shaped cell 1 can be folded in an accordion shape, test space can be saved. Further, it is possible to obtain excellent handling for conveying from a preceding step to the testing step and from the testing step to a subsequent step. Further, space for storage can be lessened. Further, since the electrode terminal plates 21, 22 for electrical connection can be sandwiched at the folded portion with the sheet-shaped cell 1 formed in an accordion shape, a plurality of segments of the sheet-shaped cell 1 can be concurrently tested to improve test efficiency. Further, specifying of a test section in the sheet-shaped cell 1 can be facilitated by specifying the electrode terminal and the conductive portion thereof being used for the test. Accordingly, specifying of an abnormal section with measurement of electrical characteristics can be facilitated as well.

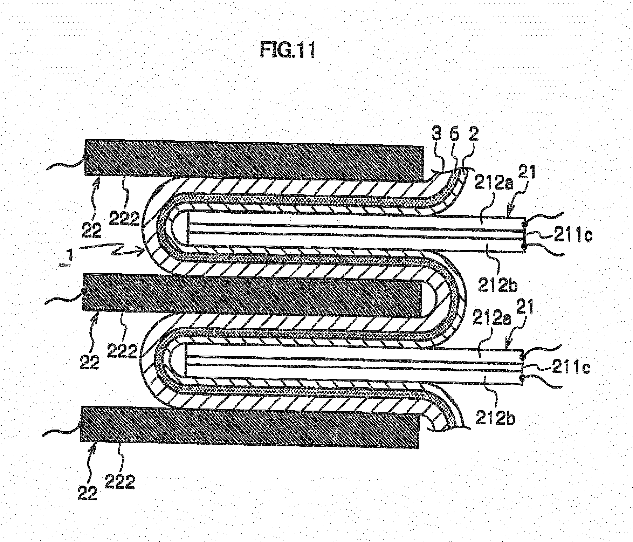

FIG. 11 is a sectional view illustrating details of a connection relation between the folded sheet-shaped cell 1 and the electrode terminal plates 21, 22. In FIG. 11, dimensions in the thickness direction of the sheet-shaped cell 1 are emphasized to clarify the connection relation.

FIG. 11 partially illustrates a case that the sheet-shaped cell 1 is alternately folded. In FIG. 11, the negative electrode layer 3 of the sheet-shaped cell 1 is in contact with the conductive portion 222 of the negative electrode terminal plate 22 and the positive electrode layer 2 of the sheet-shaped cell 1 is in contact with the conductive portions 212a, 212b of the positive electrode terminal plate 21. Owing to that the sheet-shaped cell 1 is folded, the positive electrode layer 2 is formed as being faced through the positive electrode terminal plate 21 and the negative electrode layer 3 is formed as being faced through the negative electrode terminal plate 22. The positive electrode terminal plate 21 is inserted to the extent that the leading end thereof contacts to or reaches just before an inner face of a bent section of the folded sheet-shaped cell 1. Similarly, the negative electrode terminal plate 22 is inserted to the extent that the leading end thereof contacts to or reaches just before an inner face of a bent section of the folded sheet-shaped cell 1.

Further, test segments at both ends of the sheet-shaped cell 1 are folded so that the negative electrode layer 3 is located outside and the negative electrode terminal plate 22 (conductive portion 222) is contacted to the negative electrode layer 3. In a case that a test segment at an end of the sheet-shaped cell 1 is folded so that the positive electrode layer 2 is located outside, the positive electrode terminal plate 21 may be arranged on the positive electrode layer 2 and only a wire that is connected to the conductive portion contacted to the positive electrode layer 2 may be connected to a terminal of the cell tester 106.

Owing to that the electrode terminal plates 21, 22 are contacted to the sheet-shaped cell 1, regarding one test segment, the negative electrode layer 3 is connected to the conductive portion 222 of the negative electrode terminal plate 22 and the positive electrode layer 2 is connected to the conductive portion 212a or 212b at one face of the positive electrode terminal plate 21.

Next, description will be provided on a structure of the cell supplying unit 51 with reference to FIG. 1.

The cell supplying unit 51 is for feeding the sheet-shaped cell 1 to the following cell folding step and the electrode terminal supplying step that follows thereto.

As illustrated in FIG. 1, the cell supplying unit 51 includes a sheet supplying portion 111 and a sheet drawing portion 112.

The sheet supplying portion 111 includes a roll supporting portion 114 for rotatably supporting the sheet-shaped cell 1 that is wound in a roll shape (hereinafter, simply called a sheet roll as well). The sheet roll is attached to the roll supporting portion 114 with a winding axis thereof matched with a rotation axis of the roll supporting portion 114. An unillustrated driving portion (for example, a motor or the like) may be attached to the roll supporting portion 114 to be capable of being rotated thereby.

The sheet drawing portion 112 is for drawing the sheet-shaped cell 1 fed from the sheet supplying portion 111 to a predetermined position. For example, the sheet drawing portion 112 may be configured to include a nipping portion to nip the sheet-shaped cell 1 from both faces and move the sheet-shaped cell 1 by a predetermined amount while nipping the sheet-shaped cell 1 with the nipping portion. In a case that the driving portion is arranged at the roll supporting portion 114 as described above, the sheet-shaped cell 1 may be drawn to the predetermined position while the driving portion is in cooperation to control a drawing amount of the sheet drawing portion 112 and rotation of the roll supporting portion 114.

In the present embodiment, the rotation axis of the roll supporting portion 114 is oriented in the horizontal direction and the sheet drawing direction is oriented downward in the vertical direction. Accordingly, the sheet-shaped cell 1 is to be fed from the upper side to the lower side of the testing device 100. Here, the embodiment exemplifies a case that the sheet supplying portion 111 unreels the sheet-shaped cell 1 that is roll-shaped. However, it is not limited thereto. For example, the sheet-shaped cell 1 that is in an unwound state may be fed as it is. Further, the sheet supplying portion 111 may perform positional correction to normally feed the sheet-shaped cell 1 without causing positional deviation as including a sensor to detect the fed sheet-shaped cell 1 in the width direction and a positional correction controller. Further, the sheet supplying portion 111 may include a mechanism that prevents slack from occurring at the sheet-shaped cell 1.

Next, description will be provided on a structure of the cell folding unit 52 with reference to FIG. 1. The cell folding unit 52 is for folding the sheet-shaped cell 1.

The embodiment exemplifies a case that the sheet-shaped cell 1 is folded in an accordion shape while the folding direction is changed alternately.

The cell folding unit 52 includes a sheet cutting portion 121 and a sheet folding mechanism portion 122.

The sheet cutting portion 121 is a mechanism to cut the sheet-shaped cell 1 fed from the cell supplying unit 51. The length for cutting is set in accordance with intervals and number of times of folding to be performed by the sheet folding mechanism portion 122.

The sheet folding mechanism portion 122 folds the sheet-shaped cell 1 in an accordion shape while alternately changing the folding direction.

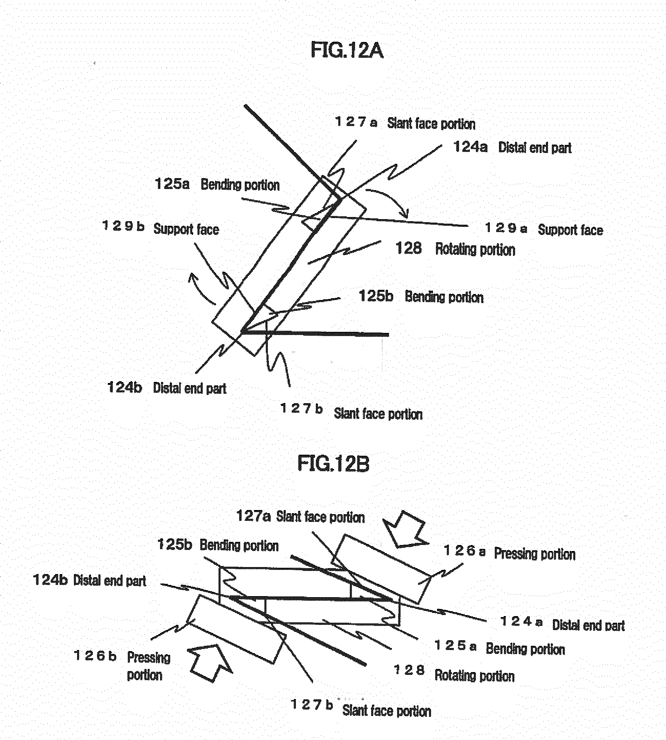

FIG. 12 is an explanatory view of an example of a folding operation of the sheet folding mechanism portion 122 according to the first embodiment.

For example, the sheet folding mechanism portion 122 includes a rotating portion 128 having a rotation axis in the width direction of the sheet-shaped cell 1 to be folded, a pair of bending portions 125a, 125b arranged at the rotating portion 128, and pressing portions 126a, 126b to crease the sheet-shaped cell 1 as pressing the sheet-shaped cell 1 to the bending portions 125a, 125b. The pair of bending portions 125a, 125b are attached to the rotating portion 128 as sandwiching the rotation axis of the rotating portion 128 and being distanced in parallel to the rotation axis. As illustrated in FIG. 12, for example, the bending portion 125a, 125b is a member having a section with a sharp angle as including a slant face portion 127a, 127b and a support face portion 129a, 129b that form the sharp distal end part 124a, 129b,. The pair of bending portions 125a, 125b are arranged on the rotating portion 128 so that the distal end parts 124a, 124b are mutually oriented outside and the slant face portions 127a, 127b are inclined to opposite sides to each other. Further, the support face portions 129a, 129b are located in parallel on the same plane or as being displaced by the order of thickness of the sheet-shaped cell 1.

In a state that the sheet-shaped cell 1 is routed between the pair of bending portions 125a, 125b, the rotating portion 128 is rotated in a direction in which the support face portions 129a, 129b are contacted to the sheet-shaped cell 1. After the support face portions 129a, 129b are contacted to the sheet-shaped cell 1, the rotating portion 128 is rotated further by a predetermined angle. According to the above, the sheet-shaped cell 1 is bent by the distal end parts 124a, 124b of the bending portions 125a, 125b. Further, the pressing portions 126a, 126b having pressing faces being approximately in parallel to the slant face portions 127a, 127b of the bending portions 125a, 125b are moved toward the slant face portions 127a, 127b to press the sheet-shaped cell 1. Thus, the sheet-shaped cell 1 is bent as having creases at positions where the distal end parts 124a, 124b of the bending portions 125a, 125b are located.

Then, the pressing portions 126a, 126b are returned to original positions after performing bending, and the rotating portion 128 is rotated in the opposite direction to an original position. Subsequently, the bent sheet-shaped cell 1 is fed by the cell supplying unit 51 as passing between the bending portions 125a, 125b.

The accordion-shaped sheet-shaped cell 1 is formed by repeating, each time when the sheet-shaped cell 1 proceeds by a predetermined distance, bending the sheet-shaped cell 1 with the bending portions 125a, 125b, pressing the sheet-shaped cell 1 with the pressing portions 126a, 126b, and feeding the sheet-shaped cell 1 by the predetermined distance after returning the bending portions 125a, 125b and the pressing portions 126a, 126b respectively to the original positions.

In the above example, since two creases can be formed at the sheet-shaped cell 1 with a single folding operation, the folding operation is performed each time when a distance by the amount of a single test segment is formed. The folded sheet-shaped cell 1 is fed to the electrode terminal supplying unit 53.

Next, description will be provided on a structure of the electrode terminal supplying unit 53 with reference to FIG. 1.

The electrode terminal supplying unit 53 is for performing sandwiching of the electrode terminal plates 21, 22 into the folded sheet-shaped cell 1. The electrode terminal supplying unit 53 includes an unillustrated sheet holding portion that performs holding so that gaps between valley-folded parts are located at predetermined positions at predetermined intervals, and an electrode terminal plate supplying portion 135 that inserts the electrode terminal plates 21, 22 to the gaps formed by the sheet holding portion. In the present embodiment, the electrode terminal plate supplying portion 135 includes a positive electrode terminal plate supplying portion 135a for inserting the positive electrode terminal plate 21 and a negative electrode terminal plate supplying portion 135b for supplying the negative electrode terminal plate 22.

A plurality of the positive electrode terminal plates 21 to be inserted are prepared in advance in the vicinity of the positive electrode terminal plate supplying portion 135a. The positive electrode terminal plate supplying portion 135a picks up one of the prepared positive electrode terminal plates 21 and inserts the positive electrode terminal plate 21 in a state of being horizontally held to a gap formed by the sheet holding portion at a portion where the positive electrode layer 2 is folded inwardly.

Similarly, a plurality of the negative electrode terminal plates 22 to be inserted are prepared in advance in the vicinity of the negative electrode terminal plate supplying portion 135b. The negative electrode terminal plate supplying portion 135b picks up one of the prepared negative electrode terminal plates 22 and inserts the negative electrode terminal plate 22 in a state of being horizontally held to a gap formed by the sheet holding portion at a portion where the negative electrode layer 3 is folded inwardly.

The abovementioned operations are repeated on the sheet-shaped cell 1 that is folded by the cell folding unit 52 and fed to the electrode terminal supplying unit 53. The sheet-shaped cell 1 with the electrode terminals inserted is stacked on the tray 101.

Regarding the upper face and lower face of the folded sheet-shaped cell 1, the electrode terminal plate corresponding to the electrode layer is arranged respectively. For example, in a case that the upper face and lower face of the accordion-shaped cell 1 are formed by the negative electrode layer 3, the negative electrode terminal plate 22 is arranged below the lower face of the accordion-shaped cell 1 and the negative electrode terminal plate 22 is arranged on the upper face thereof.

In consideration of folding intervals, sheet width, and the like of the sheet-shaped cell 1, insertion positions of the electrode terminal plates 21, 22 are set so that the conductive portions 212a, 212b, 222 of the electrode terminal plates 21, 22 are located approximately at the center of the test segment. Here, the accordion-shaped cell 1 with the electrode terminal plates 21, 22 inserted thereto may be conveyed directly to the testing step being the subsequent step. Alternatively, the accordion-shaped cell 1 may be conveyed after being temporally fixed to maintain a state of being slightly pressed from the upper and lower faces of the folded sheet-shaped cell 1. This case is preferable from a viewpoint that the electrode terminal plates 21, 22 are less likely to be misaligned.

Further, connection of the cell tester 106 with the electrode terminal plates 21, 22 may be provided by arranging connectors, for example, at appropriate positions such as both ends and midpoints of the wires 213a, 213b, 223. Here, the electrode terminal plates 21, 22 may be supplied to the sheet-shaped cell 1 in a state of being connected to the cell tester 106 or may be connected to the cell tester 106 after being supplied to the sheet-shaped cell 1. Alternatively, the electrode terminal plates 21, 22 may be connected during pressing by the pressing portion 107.

The sheet-shaped cell 1 stacked on the tray 101 is conveyed to the testing step as being kept in a state of being stacked on the tray 101.

Here, the testing device 100 may include another structural element other than the abovementioned structural elements. For example, the cell folding unit 51 may include a mechanism portion for controlling tensile force of the sheet-shaped cell 1, a mechanism portion for fixing the electrode terminal for electrical connection at a predetermined position while detecting a position in the width direction of the sheet-shaped cell 1, and the like. Further, it is also possible to arrange rollers for holding and feeding the sheet-shaped cell 1.

The embodiment exemplifies a case that the sheet-shaped cell 1 in a roll shape is folded in an accordion shape as being fed from the upper side to the lower side of the testing device 100. However, in the testing device 100, it is also possible that the sheet-shaped cell 1 in a roll shape is once moved in the horizontal direction and folded in an accordion shape and that the accordion-shaped sheet-shaped cell 1 is stacked at the lower side.

Next, operations of the testing device 100 for a cell according to the first embodiment will be described with reference to FIG. 1.

### [Step 1] Sheet-shaped cell preparing step

The sheet-shaped cell 1 wound in a roll shape is attached to the sheet supplying portion 111 and is set so that an end part of the sheet-shaped cell 1 reaches the sheet drawing portion 112.

### [Step 2] Sheet-shaped cell supplying step

After the end part of the sheet-shaped cell 1 is set, the sheet drawing portion 112 draws the sheet-shaped cell 1 to a predetermined position. Here, for example, the sheet-shaped cell 1 may be drawn downward owing to that the nipping portion included in the sheet drawing portion 112 nips both faces of the sheet-shaped cell 1 and moves downward. Alternatively, as another way, the sheet-shaped cell 1 may be drawn downward owing to that the sheet drawing portion 112 includes a pair of rollers and the pair of rollers are rotated as nipping the sheet-shaped cell 1.

Drawing of the sheet-shaped cell 1 is continued to perform appropriate supplying of necessary length thereof in synchronization with actions of the cell folding unit 52 and the electrode terminal supplying unit 53.

### [Step 3] Sheet-shaped cell folding step

After reaching the sheet folding mechanism portion 122, the drawn sheet-shaped cell 1 is bent by using bending means such as the bending portions 125a, 125b and the pressing portions 126a, 126b. Description of specific operations thereof described above will not be repeated. Owing to being alternately bent at predetermined intervals, the sheet-shaped cell 1 is folded in an accordion shape. The bent sheet-shaped cell 1 is stacked on the tray 101 arranged at the electrode terminal supplying unit 53. After being bent for predetermined times, the sheet-shaped cell 1 is cut by the sheet cutting portion 121.

### [Step 4] Electrode terminal supplying step

During stacking of the sheet-shaped cell 1 to be stacked on the tray 101 or after bending thereof, the negative electrode terminal plate 22 is inserted to a valley-folded, part at the negative electrode 3 side of the sheet-shaped cell 1 and the positive electrode terminal plate 21 is inserted to a valley-folded part at the positive electrode 2 side thereof. That is, the folded sheet-shaped cell 1 is held by the unillustrated sheet holding portion so that openings of valley-folded parts at the negative electrode 3 side are located at predetermined positions at predetermined intervals, and then, the negative electrode terminal plate supplying portion 135b waiting in a state of horizontally holding the negative electrode terminal plate 22 inserts the negative electrode terminal plate 22 to a predetermined position. Subsequently, the negative electrode terminal plate supplying portion 135b releases the inserted negative electrode terminal plate 22 and holding of the openings by the sheet holding portion is released as well. Similarly, the folded sheet-shaped cell 1 is held by the unillustrated sheet holding portion so that openings of valley-folded parts at the positive electrode layer 2 side are located at predetermined positions at predetermined intervals, and then, the positive electrode terminal plate supplying portion 135a waiting in a state of horizontally holding the positive electrode terminal plate 21 to a predetermined position. Subsequently, the positive electrode terminal plate supplying portion 135a releases the inserted positive electrode terminal plate 21 and holding of the openings by the sheet holding portion is released as well. Owing to repeating such insertion operations, the accordion-shaped cell 1 with the electrode terminal plates 21, 22 inserted thereto is stacked on the placement tray 101. Here, the electrode terminal plate to be arranged on the lower face of the accordion-shaped cell 1 is arranged in advance at a predetermined position of the tray 101 and the electrode terminal plate to be arranged on the upper face thereof is placed on the upper face after folding is completed.

### [Step 5] Electrode-terminal-plate-inserted sheet-shaped cell conveying step

The tray 101 on which the accordion-shaped cell 1 with the electrode terminal plates 21, 22 inserted thereto is conveyed to the testing unit 54 and placed on the pressing base 109.

### [Step 6] Cell tester connecting step

The positive electrode terminal plate 21 inserted to the sheet-shaped cell 1 placed on the pressing base 109 is connected to the positive electrode terminal 105a of the cell tester 106 through the wires 213a, 213b. Further, the negative electrode terminal plate 22 is connected to the negative electrode terminal 105b of the cell tester 106 through the wire 223.

### [Step 7] Pressing step

When the accordion-shaped cell 1 is placed on the pressing base 109, the pressing plate 108 of the pressing portion 107 applies pressure to the accordion-shaped cell 1 from the upper side toward the lower side. Accordingly, since pressure is applied to the accordion-shaped cell 1 as being sandwiched vertically by the pressing plate 108 and the pressing base 109, the conductive portions 212a, 212b, 222 of the electrode terminal plates 21, 22 are intimately contacted respectively to the electrode layers 2, 3 of the sheet-shaped cell 1.

### [Step 8] Testing step

After the electrode terminals 21, 22 inserted to the accordion-shaped cell 1 are connected to the cell tester 106 and contact of the electrode layers 2, 3 with the conductive portions 212a, 212b, 222 of the electrode terminal plates 21, 22 is ensured as being pressed by the pressing portion 107, the cell tester 106 performs testing as supplying power necessary for a desired test to the sheet-shaped cell 1 and measuring electrically characteristics. After testing is completed, the pressing portion 107 releases pressing on the sheet-shaped cell 1 and lifts the pressing plate 108 to predetermined height. Further, connection of the cell tester 106 with the electrode terminal plates 21, 22 is released. In a case that an abnormal section is detected through the test, the conductive portions 212a, 212b, 222 of the electrode terminal plates 21, 22 where the abnormality is detected is specified. Accordingly, a test segment of the sheet-shaped cell 1 where abnormality is detected can be specified based on information of a contact position of the conductive portion with the sheet-shaped cell 1.

### [Step 9] Discharging step

The test-completed sheet-shaped cell 1 has the electrode terminal plates 21, 22 removed and is conveyed to the subsequent step continuously as being folded in an accordion shape on the tray 101.

The subsequent step includes processing such as cutting, layering, and winding of the sheet-shaped cell 1, attaching of a mount component such as an electrode terminal, a cover member, and an exterior member, and the like.

Here, the sheet-shaped cell 1 may be formed of a single test segment or formed by superposing a plurality of separated test segments. Alternatively, it is also possible to be superposed as being folded in an accordion shape without being separated. In a case that a plurality of the sheet-shaped cells 1 are superposed, the respective sheet-shaped cells 1 can be connected in series or in parallel. In a case that there exists a test segment that is determined as being a malfunction section in the testing step, the test segment may be removed.

In the embodiment, description is provided on a case that the electrode terminal plates 21, 22 are test-dedicated electrode terminal plates 21, 22 to be connected to the cell tester 106. However, it is also possible to function as electrode terminal plates for electrical connection of a battery product. In this case, after the testing step is completed, the sheet-shaped cell 1 is conveyed to a subsequent step after only releasing connection with the cell tester 106 without the electrode terminal plates 21, 22 are removed.

### (A-4) Effects of first embodiment

As described above, according to the first embodiment, since the sheet-shaped cell is alternately folded and the electrode terminals are inserted to gaps at the folded sheet-shaped cell, test space can be saved by lessening a size of the testing device for a cell. Further, since the sheet-shaped cell can be tested concurrently at a plurality of segments, test time can be shortened. Further, handling can be facilitated for conveying the sheet-shaped cell being a test object from the electrode terminal supplying step to the testing step or discharging from the testing step to a subsequent step.

Further, since the conductive portion at the upper face and the conductive portion at the lower face of the positive electrode terminal plate are insulated by the insulation layer, power supplying for testing and measuring of electrical characteristics can be performed for each test segment.

Further, since the folded sheet-shaped cell is pressed at least during testing, it is possible to prevent loose contact to be caused by restoring force generated by being folded in an accordion shape.

### (B) Second embodiment

Next, a second embodiment of a sheet-shaped cell testing device and a sheet-shaped cell testing method according to the present invention will be described in detail with reference to the drawings.

Similarly to the first embodiment, the second embodiment also exemplifies a case that a sheet-shaped cell is a quantum cell.

Further, similarly to the first embodiment, the cell testing device can be widely applied to a device that examines or tests cell performance.

### (B-1) Sheet-shaped quantum cell being test object

A sheet-shaped quantum cell being a test object in the second embodiment will be described with reference to the drawings.

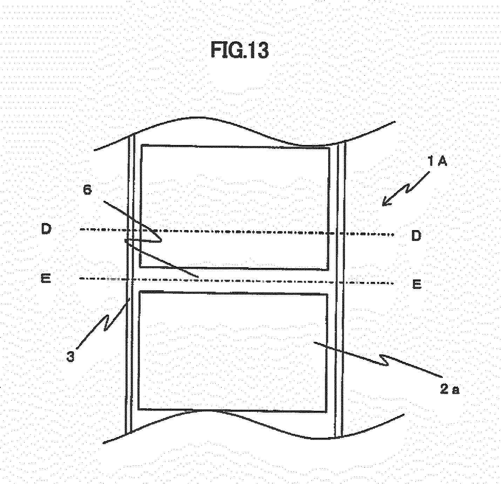

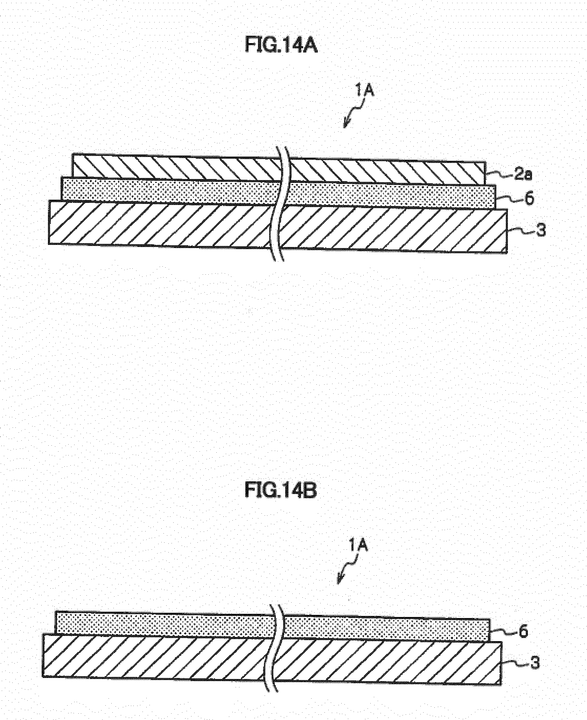

FIGs. 13 and 14 illustrate a sheet-shaped quantum cell 1A (hereinafter, simply called a sheet-shaped cell 1A as well) according to the second embodiment. FIG. 13 is a front view of the sheet-shaped cell 1A. FIG. 14(A) is a sectional view of the sheet-shaped cell 1A at line D-D in FIG. 13 and FIG. 14(B) is a sectional view of the sheet-shaped cell 1A at line E-E in FIG. 13.

As illustrated in FIGs. 13 and 14, similarly to the sheet-shaped cell 1 according to the first embodiment, the sheet-shaped cell 1A according to the second embodiment has an elongated thin-plate shape having the basic structure in which a negative electrode layer 3, a charging layer 6, and a positive electrode layer 2a are layered in the order thereof. Here, it is different from the first embodiment in that a plurality of the positive electrode layers 2a are discontinuously formed. That is, the positive electrode layers 2a are layered on the charging layer 6 as being aligned and distanced in the longitudinal direction of the sheet-shaped cell 1A. In this example, the respective positive electrode layers 2a are formed rectangular having the same front view shape. Between respective adjacent positive electrode layers 2a, a section where the positive electrode layer is not formed (a section where only having the negative electrode layer 3 and the charging layer 6 are layered) is formed as having constant width. Since the section where the positive electrode layer 2a is not formed corresponds to a bent section for bending in an accordion shape, each segment divided by the section where the positive electrode layer is not formed is to be a single test segment. For discontinuously forming the positive electrode layers 2a, the positive electrode layers 2a may be discontinuously generated at the time of forming thereof. Alternatively, the positive electrode layers 2a may be formed by uniformly forming a positive electrode layer as being similar to the first embodiment, and then, scraping or eliminating (for example, with etching, laser irradiation, or the like) the positive electrode layer. Being the same as the first embodiment other than the abovementioned, description thereof will not be repeated.

Since the positive electrode layer 2 is not formed at the bent section, power supplying for testing and measuring of electrical characteristics can be performed for each test segment. Accordingly, measurement results for the respective test segments can be obtained more accurately.

### (B-2) Structure of second embodiment

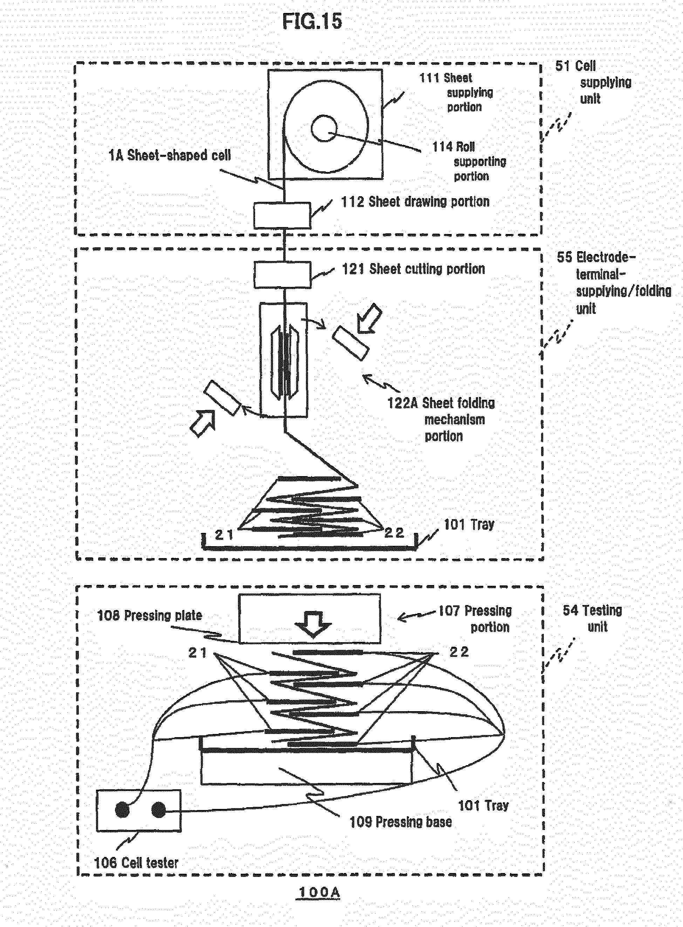

FIG. 15 is a structural view illustrating a general structure of a testing device 100A of the second embodiment. The same numeral is given to the same structure as the first embodiment to skip description thereof and description will be provided mainly on differences from the first embodiment.

The testing device 100A according to the second embodiment includes a cell supplying unit (cell supplying step) 51 that supplies the sheet-shaped cell 1A, an electrode-terminal-supplying/folding unit (electrode-terminal-supplying/folding step) 55 that performs folding while electrode terminal plates (a positive electrode terminal plate 21 and a negative electrode terminal plate 22) are supplied to the sheet-shaped cell 1A supplied from the cell supplying unit 51, and a testing unit (testing step) 54 that tests the sheet-shaped cell 1A that is folded by the electrode-terminal-supplying/folding unit 55 while the electrode terminal plates 21, 22 are supplied thereto.

Since the cell supplying unit 51 and the testing unit 54 being the same as or corresponding to those in the testing device 100 according to the first embodiment may be adopted, detailed description thereof will not be repeated.

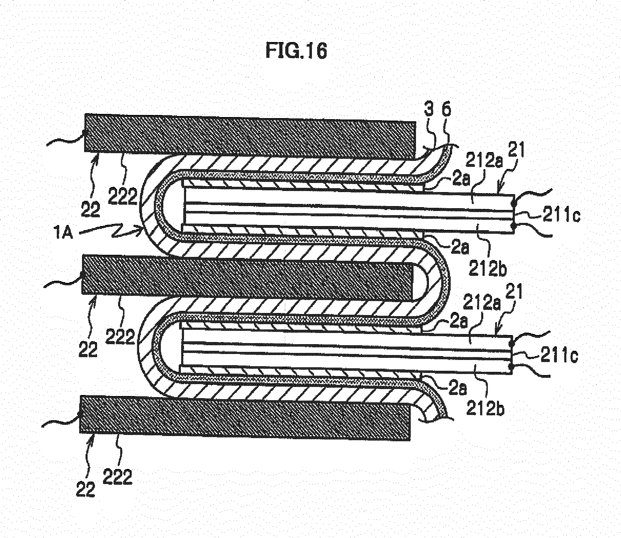

FIG. 16 is a sectional view illustrating details of a connection relation between the folded sheet-shaped cell 1A and the electrode terminal plates 21, 22 as partly illustrating a case that the sheet-shaped cell 1 is alternately folded. In FIG. 16, dimensions in the thickness direction of the sheet-shaped cell 1A are emphasized to clarify the connection relation.

As illustrated in FIG. 16, being different from the first embodiment, a section where the positive electrode layer is not formed is located respectively at a crease section at which the positive electrode layer 2a is folded inwardly and a crease section where the positive electrode layer 2a is folded outwardly. Owing to that the sheet-shaped cell 1A is folded, two positive electrode layers 2a located at the same inwardly folded portion are faced to each other through the positive electrode terminal plate 21. Then, each of the positive electrode layers 2a of the sheet-shaped cell 1A is in contact with the conductive portion 212a or 212b of the positive electrode terminal plate 21. Being the same as in FIG. 11 for the first embodiment other than the abovementioned, detailed description thereof will not be repeated.

The electrode-terminal-supplying/folding unit 55 forms the accordion-shaped sheet-shaped cell 1A as folding the sheet-shaped cell 1A fed from the cell supplying unit 51 while the folding direction is changed alternately and concurrently inserting the electrode terminal plates 21, 22 for electrical connection into the folded sheet-shaped cell 1A.

The electrode-terminal-supplying/folding unit 55 includes a sheet cutting portion 121 and a sheet folding mechanism portion 122A. Since the sheet cutting portion 121 is the same as or corresponds to that in the first embodiment, detailed description thereof will not be repeated.

The sheet folding mechanism portion 122A places the electrode terminal plates 21, 22 at one face side or both face sides of the sheet-shaped cell 1A fed from the cell supplying unit 51, holds the electrode terminal plates 21, 22 along with the sheet-shaped cell 1A from both outer sides, and folds the sheet-shaped cell 1A while supporting the electrode terminal plates 21, 22.

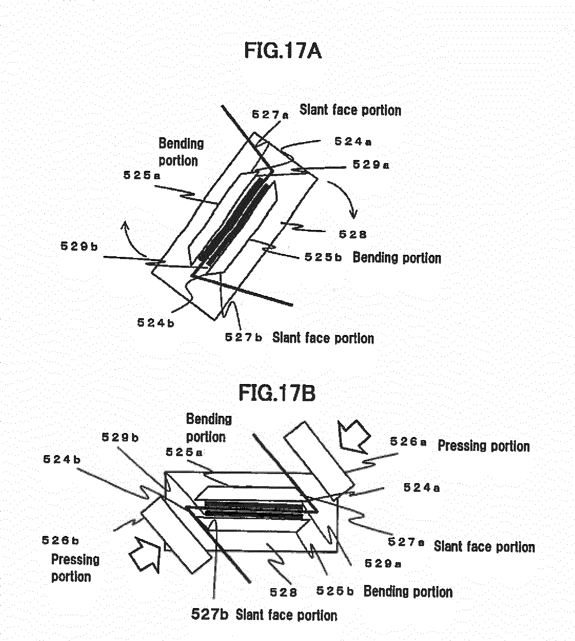

FIG. 17 is an explanatory view of an example of an operation of the sheet folding mechanism portion 122A according to the second embodiment.

For example, the sheet folding mechanism portion 122A includes an unillustrated electrode terminal plate supplying portion that places the electrode terminal plates 21, 22 in parallel to a surface of the sheet-shaped cell 1A to be close thereto, a pair of bending portions 525a, 525b that rotates as having an axis in the width direction of the sheet-shaped cell 1A while nipping the sheet-shaped cell 1A from both face sides along with the electrode terminal plates 21, 22 supplied by the electrode terminal plate supplying portion, a nip movable portion 528 that causes the pair of bending portions 525a, 525b to be close to each other and to rotate with each other, and pressing portions 526a, 526b to crease the sheet-shaped cell 1A as pressing the sheet-shaped cell 1A to the bending portions 525a, 525b.

As illustrated in FIG. 17, for example, the bending portion 525a, 525b is a member having sections with a sharp angle at both distal ends as including a slant face portion 527a, 527b and a nip face portion 529a, 529b that form a sharp distal end part 524a, 524b. The pair of bending portions 525a, 525b are arranged so that the distal end parts 524a, 524b are in parallel to the width direction of the sheet-shaped cell 1A to be folded and so that the nip face portions 529a, 529b are displaced and faced to each other.

In a state that the sheet-shaped cell 1A is routed between the pair of bending portions 525a, 525b, the electrode terminal plate supplying portion causes the negative electrode terminal plate 22 to be close to the negative electrode layer 3 side of the sheet-shaped cell 1A and causes the positive electrode terminal plate 21 to be close to the positive electrode layer 2 side thereof. The nip movable portion 528 nips the sheet-shaped cell 1A along with the electrode terminal plates 21, 22 as moving the bending portions 525a, 525b so that the nip face portions 529a, 529b are mutually closed. Subsequently, the nip movable portion 528 rotates the bending portions 525a, 525b as keeping the nipping state by a predetermined angle, for example until the nip faces 529a, 529b become horizontal. According to the above, the sheet-shaped cell 1A is bent by the distal end parts 524a, 524b of the bending portions 525a, 525b.

Further, the pressing portions 526a, 526b having pressing faces being approximately in parallel to the slant face portions 527a, 527b of the bending portions 525a, 525b are moved toward the slant face portions 527a, 527b to press the sheet-shaped cell 1A. Thus, the sheet-shaped cell 1A is bent as having creases at positions where the distal end parts 524a, 524b or the bending portions 525a, 525b are located.

Then, the pressing portions 526a, 526b are returned to original positions after performing bending, and the bending portions 525a, 525b are moved by the nip movable portion 528 in directions to be apart from each other to release the nipped state. Subsequently, the bent sheet-shaped cell 1A is fed by the cell supplying unit 51. At that time, the bending portions 525a, 525b retract to a position not to disturb moving of the sheet-shaped cell 1A as needed.

The accordion-shaped sheet-shaped cell 1A is formed by repeating, each time when the sheet-shaped cell 1A proceeds by predetermined distance, bending the sheet-shaped cell 1A with the bending portions 525a, 525b, pressing the sheet-shaped cell 1A with the pressing portions 526a, 526b, and feeding the sheet-shaped cell 1A by the predetermined distance after releasing pressing with the pressing portions 526a, 526b and nipping with the bending portions 525a, 525b. The sheet-shaped cell 1A with the electrode terminals inserted is stacked on the tray 101.

In the above example, the electrode terminals can be supplied to both faces of the sheet-shaped cell 1A and two creases can be formed at the sheet-shaped cell 1A with a single folding operation. Therefore, the folding operation is performed each time when a distance by the amount of a single test segment is formed. Further, feeding of the sheet-shaped cell is adjusted so that a section where the positive electrode layer 2 is not formed is located at the crease.

Here, intervals for performing a folding operation, rotation directions of the bending portions 525a, 525b, supplying fashions of the electrode terminal plates, and the like may be appropriately varied as long as the sheet-shaped cell 1A is alternately folded and a single electrode terminal plate is inserted to each valley-folded part.

The sheet-shaped cell 1A stacked on the tray 101 is conveyed to the testing step in a state of being stacked on the tray 101.

Next, operations of the testing device 100A according to the second embodiment will be described with reference to FIG. 15.

Since steps 1 and 2 and steps 5 to 9 with the testing device 100 in the first embodiment are the same as or correspond to those in the second embodiment, detailed description thereof will not be repeated. In the following, operations between step 2 and step 5 will be described.

### [Electrode terminal supplying and cell folding step]

After the sheet-shaped cell 1A is fed to a predetermined position from the cell supplying unit 51 to the electrode-terminal-supplying/folding unit 55, the sheet folding mechanism portion 122A supplies the electrode terminal plates 21, 22 with the electrode terminal plate supplying portion and bending is performed by using bending means such as the bending portions 525a, 525b and the pressing portions 526a, 526b. Description of specific operations thereof described above will not be repeated. Owing to the above, the sheet-shaped cell 1A can be folded, and concurrently, the positive electrode terminal plate 21 and the negative electrode terminal plate 22 can be arranged at the folded portions of the sheet-shaped cell 1A folded in an accordion shape. The bent sheet-shaped cell 1A is stacked on the tray 101. After being bent for predetermined times, the sheet-shaped cell 1A is cut by the sheet cutting portion 121. Here, the electrode terminal plate to be arranged on the lower face of the accordion-shaped cell 1A may be arranged in advance at a predetermined position of the tray 101 and the electrode terminal plate to be arranged on the upper face thereof may be placed on the upper face after folding is completed.

### (B-3) Effects of second embodiment

As described above, according to the second embodiment, since the sheet-shaped cell is folded in a state that the electrode terminals are sandwiched, effects similar to those in the first embodiment can be obtained. Further, in the second embodiment, since folding is performed in a state that the electrode terminals are contacted, it is not required to perform a step to insert the electrode terminals to the sheet-shaped cell after the folding. Accordingly, device simplification and processing time shortening can be achieved.

Further, since the positive electrode layer 2 is not formed at the bent section, power supplying for testing and measuring of electrical characteristics can be performed for each test segment. Accordingly, measurement results can be obtained more accurately.

### (C) Third embodiment

Next, a third embodiment of a sheet-shaped cell testing device and a sheet-shaped cell testing method according to the present invention will be described with reference to the drawings.

Similarly to the first embodiment, the third embodiment also exemplifies a case that a sheet-shaped cell is a quantum cell.

Further, similarly to the first embodiment, the cell testing device can be widely applied to a device that examines or tests cell performance.

### (C-1) Sheet-shaped quantum cell being test object

A sheet-shaped cell being a test object in the third embodiment will be described with reference to the drawings.

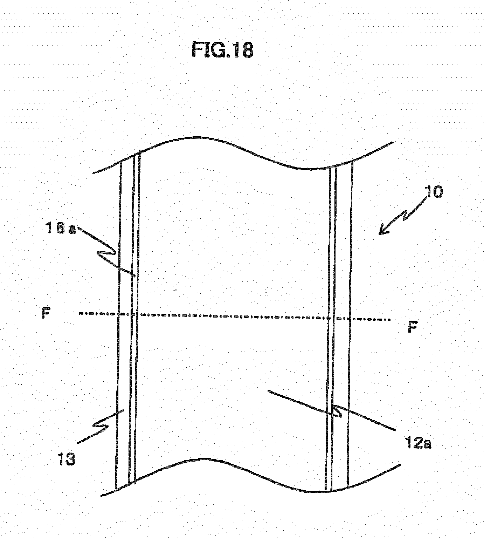

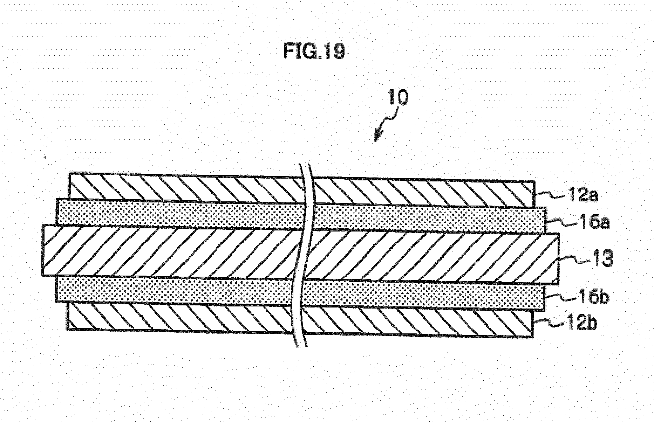

FIGs. 18 and 19 illustrate a sheet-shaped quantum cell 10 (hereinafter, simply called a sheet-shaped cell 10 as well) according to the third embodiment. FIG. 18 is a front view of the sheet-shaped cell 10 and FIG. 19 is a sectional view of the sheet-shaped cell 10 at line F-F in FIG. 18.

As illustrated in FIGs. 18 and 19, the sheet-shaped cell 10 according to the third embodiment has an elongated thin-plate shape having the basic structure of the abovementioned quantum cell in which a negative electrode layer 13, charging layers 16a, 16b, and positive electrode layers 12a, 12b are layered. Here, it is different from the first sheet-shaped cell 1 of the first embodiment in that the charging layer 16a, 16b and the positive electrode layer 12a, 12b are sequentially layered on each face of the negative electrode layer 13. That is, the charging layer 16a and the positive electrode layer 12a are sequentially layered on one face of the negative electrode layer 13. The charging layer 16b and the positive electrode layer 12b are sequentially layered on the other face of the negative electrode layer 13. At an edge portion (for example, an end part in the width direction or the length direction) of the negative electrode layer 13, there is arranged a section that is not covered by the charging layers 16a, 16b and the positive electrode layers 12a, 12b. Such a section is used for connection with a negative electrode terminal of a cell tester. In the present embodiment, width of the negative electrode layer 13 is larger than that of the charging layers 16a, 16b and that of the positive electrode layers 12a, 12b. Further, the respective layers are layered as being aligned at the center in the width direction. Accordingly, sections of the negative electrode layer 3 that are not covered by the charging layers 16a, 16b and the positive electrode layers 12a, 12b are formed at both sides in the width direction of the sheet-shaped cell 10. Being the same as the first embodiment other than the abovementioned, description thereof will not be repeated.

As described above, since the sheet-shaped cell 10 according to the third embodiment has the charging layers 16a, 16b on both faces, a storage amount per front area can be enlarged.

### (C-2) Structure of third embodiment

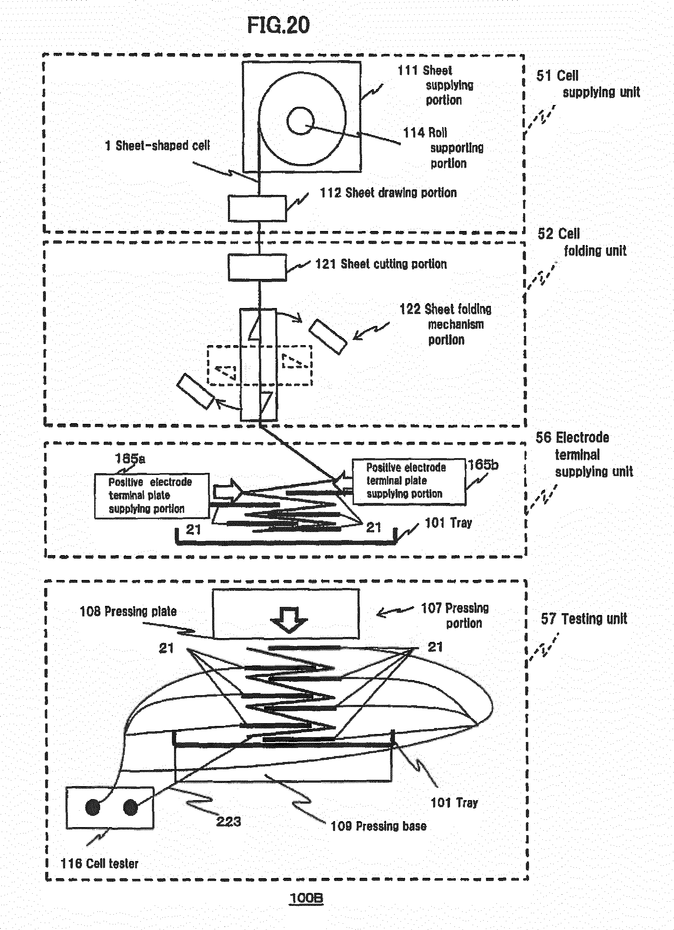

FIG. 20 is a structural view illustrating a general structure of a testing device 100B of the third embodiment. The same numeral is given to the same structure as the first embodiment to skip description thereof and description will be provided mainly on differences from the first embodiment.

The testing device 100B according to the third embodiment includes a cell supplying unit (cell supplying step) 51 that supplies the sheet-shaped cell 10, a cell folding unit (cell folding step) 52 that folds the sheet-shaped cell 10 supplied from the cell supplying unit 51, an electrode terminal supplying unit (electrode terminal supplying step) 56 that supplies an electrode terminal into the sheet-shaped cell 10 folded by the cell folding unit 52, and a testing unit (testing step) 57 that tests the sheet-shaped cell 10 into which the electrode terminal is supplied by the electrode terminal supplying unit 56.

Since the cell supplying unit 51 and the cell folding unit 52 being the same as or corresponding to those in the testing device 100 according to the first embodiment may be adopted, detailed description thereof will not be repeated.

The electrode terminal supplying unit 56 is for performing sandwiching of the positive electrode terminal plates 21 into the folded sheet-shaped cell 10. The positive electrode terminal plate 21 described in the first embodiment may be used as the positive electrode terminal plate.

The electrode terminal supplying unit 56 includes an unillustrated sheet holding portion that holds the sheet-shaped cell 10 so that gaps between valley-folded parts are located at predetermined positions at predetermined intervals, and an electrode terminal plate supplying portion 165 that inserts the electrode terminal plates 21 to the gaps formed by the sheet holding portion.

In the present embodiment, the electrode terminal plate supplying portion 165 includes a positive electrode terminal plate supplying portion 165a for inserting the positive electrode terminal plate 21 to the valley-folded part being open to one side and a positive electrode terminal plate supplying portion 165b for inserting the positive electrode terminal plate 21 to the valley-folded part being open to the other side.

A plurality of the positive electrode terminal plates 21 to be inserted are prepared in advance in the vicinity of the positive electrode terminal plate supplying portions 165a, 165b. Each of the positive electrode terminal plate supplying portions 165a, 165b picks up one of the prepared positive electrode terminal plates 21 and inserts the positive electrode terminal plate 21 in a state of being horizontally held to a gap formed by the sheet holding portion at the valley-folded part of the sheet-shaped cell 10.

The abovementioned operations are repeated on the sheet-shaped cell 10 that is folded by the cell folding unit 52 and fed to the electrode terminal supplying unit 56. The sheet-shaped cell 10 with the positive electrode terminal plates inserted is stacked on the tray 101.

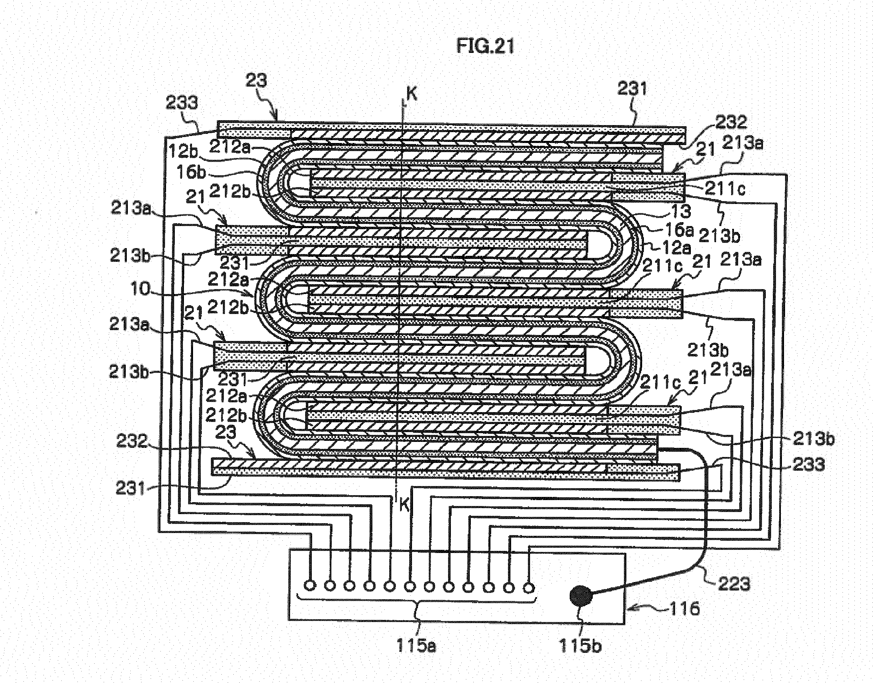

Regarding the upper face and lower face of the folded sheet-shaped cell 10, a positive electrode terminal plate 23 having a conductive portion only on one face (called a one-face positive electrode terminal plate 23) may be used. As illustrated in FIG. 21, in the one-face positive electrode terminal plate 23, an insulation layer 231 is formed on one face and a conductive portion 232 formed of a conductive material is formed on the other face. A wire 233 is connected to an end part of the conductive portion 232. Since there is a possibility that the end part at the side where the wire 233 is connected is protruded from the upper or lower face when being arranged on the upper or lower face of the folded sheet-shaped cell 10, both faces thereof are covered respectively with an insulation layer. The wire 233 is connected to a positive electrode terminal 115a of the cell tester 116. Similarly to the conductive portion 212 of the positive electrode terminal plate 21, the conductive portion 232 of the one-face positive electrode terminal plate 23 may function at the entire face thereof for electrical contact or may function partially or at multiple points for electrical contact. The one-face positive electrode terminal plate 23 is arranged on the upper face or the lower face of the folded sheet-shaped cell 10 as being oriented so that the conductive portion 232 is to be contacted. Arranging of the above may be performed by using the positive electrode terminal plate supplying portion 165a, 165b. Alternatively, it is also possible to arrange the one-face positive electrode terminal plate 23 in advance on the tray 101 or to place on the upper face of the folded sheet-shaped cell with other means.

The sheet-shaped cell 10 stacked on the tray 101 is conveyed to the testing step as being kept in a state of being stacked on the tray 101.

Similarly to the first embodiment, the testing unit 57 performs testing of the sheet-shaped cell 10 as including a cell tester 116 and a pressing portion 107. Since the pressing portion 107 being the same or corresponding to that in the testing unit 100 according to the first embodiment may be adopted, detailed description thereof will not be repeated.

The cell tester 116 performs power supplying and electrical characteristic measuring required for performing testing such as cell performance check, a charging-discharging test, conditioning, a charging-discharging cycle test, and an aging test on the sheet-shaped cell 10 folded by the cell folding unit 52 using the positive electrode terminal plates 21, 23 for electrical connection arranged therein and on the upper and lower faces.

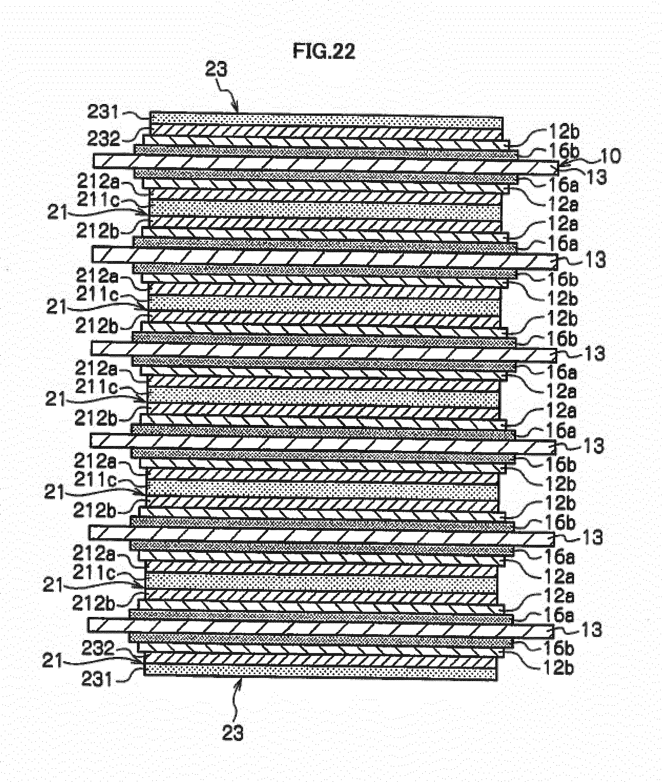

FIG. 21 is a view illustrating a connection relation between the folded sheet-shaped cell 10 and the cell tester 116 according to the third embodiment. FIG. 22 is a sectional view at line K-K in FIG. 21. FIG. 21 illustrates, in a sectional view, a contact state between the folded sheet-shaped cell 10 and the positive electrode terminal plates 21, 23 for electrical connection arranged therein and on the upper and lower faces. Further, a connection relation between the cell tester 116 and the positive electrode terminal plates 21, 23 to be contacted to the sheet-shaped cell 10 is illustrated as well . In FIGs . 21 and 22, dimensions in the thickness direction of the sheet-shaped cell 10 are emphasized to clarify the connection relation. Further, although FIG. 21 illustrates an example of folding in six, the number of folding is not limited thereto.

As illustrated in FIG. 21, the sheet-shaped cell 10 folded by the cell folding unit 52 is formed in an accordion shape. Here, the positive electrode terminal plates 21 are inserted to gaps formed at inwardly-folded portions, respectively. Further, the one-face positive electrode terminal plate 23 is arranged at each of the upper and lower faces of the folded sheet-shaped cell.

In FIG. 21, the positive electrode layers 12a, 12b of the sheet-shaped cell 10 are in contact with conductive portions of the positive electrode terminal plates 21, 23, respectively. Owing to that the sheet-shaped cell 10 is folded, the positive electrode layer 12a is formed in an opposed manner through the positive electrode terminal plate 21 and the positive electrode layer 12b is formed in an opposed manner through the positive electrode terminal plate 21.

Each of test segments at both ends of the sheet-shaped cell 10 is folded so that the positive electrode layer 12b is located outside. The one-face positive electrode terminal plate 23 is arranged so that the conductive portion 232 thereof is contacted to the positive electrode layer 12b. In this example, the one-face positive electrode terminal plate 23 is used on each of the upper and lower faces of the folded sheet-shaped cell. However, it is also possible to use the same one as the positive electrode terminal plate 21 inserted thereto. In such a case, only the wire 213 that is connected to the conductive portion 212 in contact with the positive electrode layer 12 may be connected to a connection terminal of the cell tester 116.

The cell tester 116 supplies power for testing (for example, applies voltage or flows current) as connecting the positive electrode terminal plate 21 that is in contact with the accordion-shaped cell 10 to the positive electrode terminal 115a as an electrode terminal for electrical connection and connecting an exposed part of the negative electrode layer 13 of the sheet-shaped cell 10 to the negative electrode terminal 115b.

The positive electrode terminal plate 21 is connected to the positive electrode terminal 115a of the cell tester 116 through the wire 213a, 213b and the one-face positive electrode terminal plate 23 is connected thereto through the wire 233. Further, the negative electrode layer 13 of the sheet-shaped cell 10 is connected to the negative electrode terminal 115b of the cell tester 116 through the wire 223. Connection between the negative electrode layer 13 and the wire 223 can be obtained by using a part of the negative electrode layer 13 where the charging layer 16 and the positive electrode layer 12 are not formed. Here, the connection may be provided at one position or a plurality of positions (for example, at each test segment). Further, the connection may be provided through a connection terminal arranged at the negative electrode layer 13.

Here, in addition to a function to apply voltage or to flow current between the positive electrode terminal plate 21 and the negative electrode layer 13, the cell tester 116 may have a function to measure electrical characteristics such as current and voltage between the positive electrode terminal plate 21 and the negative electrode layer. The cell tester 116 may have a function to determine whether or not the measured electrical characteristics are within a previously-registered allowable range and to determine whether a cell at a measurement section is normal or abnormal. The abnormal section is determined by specifying the positive electrode terminal plate 21, 23 or the conductive portion thereof where the measurement value determined as being abnormal is measured.

After the test is completed, the electrode terminal plates 21, 23 are removed from the sheet-shaped cell 10 and the sheet-shaped cell 10 is conveyed to the nest step or stored as being maintained in an accordion shape. Here, a cell at a section where abnormality is detected in the testing step (for example, a test segment being in contact with the conductive portion of the positive electrode terminal plate where abnormality is detected) can be repaired or removed in a subsequent step.

### (C-3) Effects of third embodiment

As described above, according to the third embodiment, since the sheet-shaped cell is alternately folded and the electrode terminals are inserted to gaps at the folded sheet-shaped cell, the effects similar to those in the first embodiment can be obtained.

Further, since the conductive portion at the upper face and the conductive portion at the lower face of the positive electrode terminal plate are insulated by the insulation layer, power supplying for testing and measuring of electrical characteristics can be performed for each test segment.

Further, in the third embodiment, surfaces on both sides of the sheet-shaped cell being a test object are formed respectively of the positive electrode layer, and the positive electrode terminal plates are placed at valley-folded parts and the upper and lower faces of the folded sheet-shaped cell. In this case as well, measuring can be performed for each test segment or each face of test segments and an abnormal section can be easily specified.

### (D) Fourth embodiment

Next, a fourth embodiment of a sheet-shaped cell testing device and a sheet-shaped cell testing method according to the present invention will be described in detail with reference to the drawings.

Similarly to the first embodiment, the fourth embodiment also exemplifies a case that a sheet-shaped cell is a quantum cell.

Further, similarly to the first embodiment, the cell testing device can be widely applied to a device that examines or tests cell performance.

### (D-1) Sheet-shaped quantum cell being test object

A sheet-shaped quantum cell being a test object in the fourth embodiment will be described with reference to the drawings.

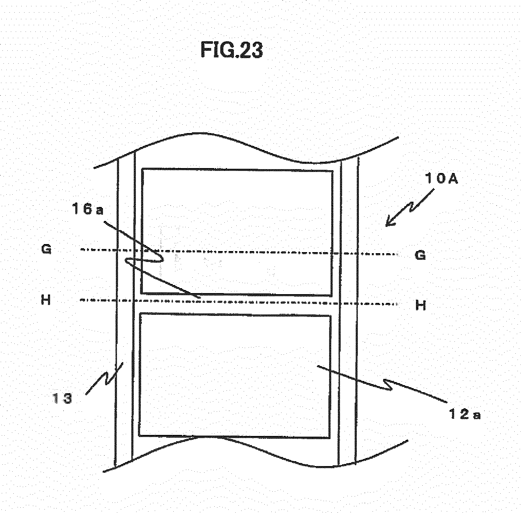

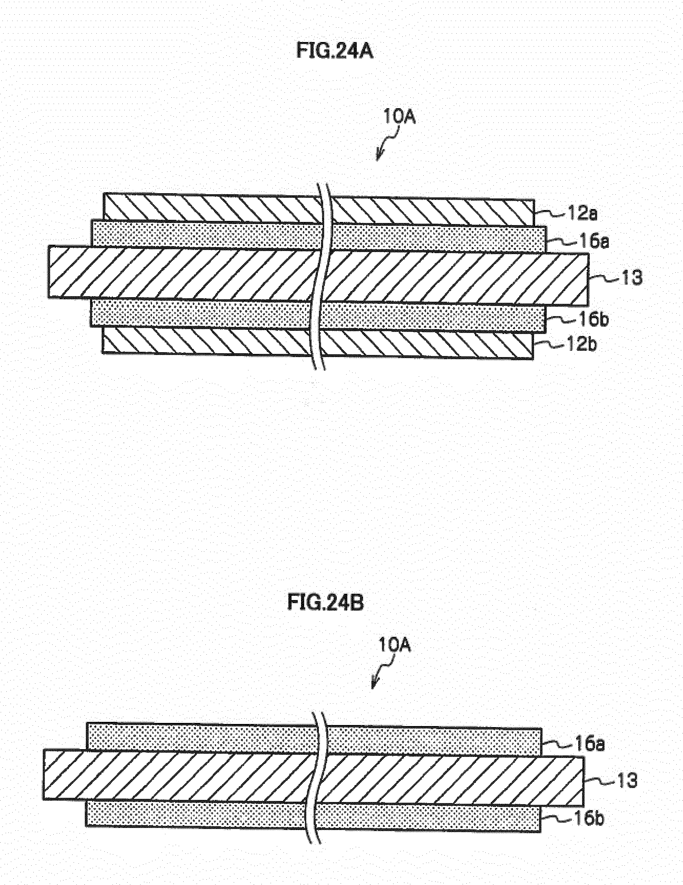

FIGs. 23 and 24 illustrate a sheet-shaped quantum cell 10A (hereinafter, simply called a sheet-shaped cell 10A as well) according to the fourth embodiment. FIG. 23 is a front view of the sheet-shaped cell 10A. FIG. 24(A) is a sectional view of the sheet-shaped cell 10A at line G-G in FIG. 23 and FIG. 24(B) is a sectional view of the sheet-shaped cell 10A at line H-H in FIG. 23.

As illustrated in FIGs. 23 and 24, the sheet-shaped cell 10A according to the fourth embodiment has an elongated thin-plate shape in which the charging layer 16a and the positive electrode layer 12a are sequentially layered on one face of the negative electrode layer 13 and the charging layer 16b and the positive electrode layer 12b are sequentially layered on the other face thereof as being similar to the sheet-shaped cell 10 according to the third embodiment. Here, it is different from the third embodiment in that the positive electrode layers 12a, 12b are discontinuously formed. That is, the positive electrode layers 12a are layered on the charging layer 16a as being aligned and distanced in the longitudinal direction of the sheet-shaped cell 10A and the positive electrode layers 12b are layered on the charging layer 16b as being aligned and distanced in the longitudinal direction of the sheet-shaped cell 10A. The positive electrode layers 12a and the positive electrode layers 12b are formed as being symmetric about the negative electrode layer 13. In this example, the respective positive electrode layers 12a, 12b are formed rectangular having the same front view shape. Between respective adjacent positive electrode layers 12a, 12b, a section where the positive electrode layer is not formed (a section where only having the negative electrode layer 13 and the charging layers 16a, 16b are layered) is formed as having constant width. Since the section where the positive electrode layer is not formed corresponds to a bent section for bending in an accordion shape, a segment divided by the section where the positive electrode layer is not formed is to be a single test segment. For discontinuously forming the positive electrode layers 12a, 12b, the positive electrode layers 12a, 12b may be discontinuously generated at the time of forming thereof. Alternatively, the positive electrode layers 12a, 12b may be formed by uniformly forming a positive electrode layer as being similar to the third embodiment, and then, scraping or eliminating (for example, with etching, laser irradiation, or the like) the positive electrode layer. Being the same as the third embodiment other than the abovementioned, description thereof will not be repeated.

Since the positive electrode layer is not formed at the bent section, power supplying for testing and measuring of electrical characteristics can be performed for each test segment. Accordingly, measurement results can be obtained more accurately.

### (D-2) Structure of fourth embodiment

Since the testing device 100B of the third embodiment may be adopted as the testing device of the fourth embodiment, the same numeral is given to the same structure as the third embodiment to skip description thereof and description will be provided mainly on differences from the third embodiment.

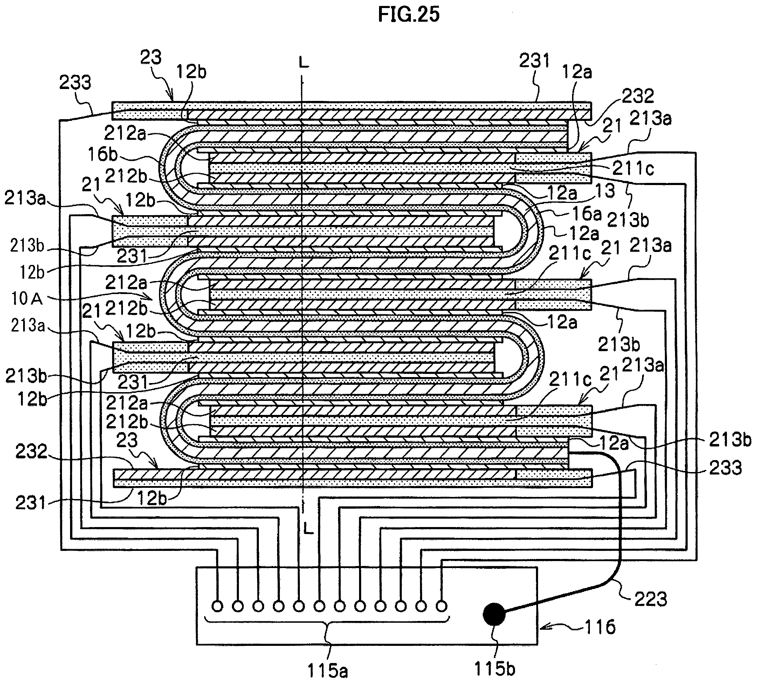

FIG. 25 is a view illustrating a connection relation between the folded sheet-shaped cell 10A and the cell tester 116 according to the fourth embodiment. FIG. 25 illustrates, in a sectional view, a contact state between the folded sheet-shaped cell 10A and the positive electrode terminal plates 21, 23 for electrical connection arranged therein and on the upper and lower faces. Further, a connection relation between the cell tester 116 and the positive electrode terminal plates 21, 23 to be contacted to the sheet-shaped cell 10A is illustrated as well. Since a sectional view at line L-L in FIG. 25 is the same as the sectional view (see FIG. 22) at line K-K in FIG. 21, description thereof will not be repeated. In FIG. 25, dimensions in the thickness direction of the sheet-shaped cell 10A are emphasized to clarify the connection relation. Further, although FIG. 25 illustrates an example of folding in six, the number of folding is not limited thereto.

As illustrated in FIG. 25, being different from the third embodiment, a section where the positive electrode layer is not formed is located respectively at both faces of a crease section at which the sheet-shaped cell 10A is folded. Owing to that the sheet-shaped cell 10A is folded, two positive electrode layers 12a, 12b located at the same inwardly folded portion are faced to each other through the positive electrode terminal plate 21. Then, each of the positive electrode layers 12a formed on one face of the sheet-shaped cell 10A is in contact with the conductive portion 212a or 212b of the positive electrode terminal plate 21. Each of the positive electrode layers 12b formed on the other face of the sheet-shaped cell 10A is in contact with the conductive portion 212a, 212b or 232 of the positive electrode terminal plate 21 or 23. Being the same as in FIG. 21 for the third embodiment other than the abovementioned, detailed description thereof will not be repeated.

### (D-3) Effects of fourth embodiment

As described above, according to the fourth embodiment, since the sheet-shaped cell is alternately folded and the electrode terminals are inserted to gaps at the folded sheet-shaped cell, the effects similar to those in the first embodiment can be obtained.

Further, since the positive electrode layer is not formed at the bent section, power supplying for testing and measuring of electrical characteristics can be performed for each test segment or each face of test segments. Accordingly, measurement results can be obtained more accurately.

### (E) Other embodiments

A variety of modified embodiments are described in the description of the abovementioned embodiments. In addition, modified embodiments described in the following may be adopted.

The respective embodiments described above exemplify a case that the electrode terminal plates are alternately inserted to all folded portions. However, it is also possible to perform inserting only to a part of folded portions. For example, it is also possible to perform inserting at regular intervals such as alternate inserting.

The sheet-shaped cell 1 being a test object of the first embodiment may be tested using the testing device 100A of the second embodiment. Further, the sheet-shaped cell 1A being a test object of the second embodiment may be tested using the testing device 100 of the first embodiment.

Further, the respective embodiments described above exemplify a case that the electrode terminal plates are arranged on the upper and lower faces of the folded sheet-shaped cell. However, it is also possible to cause the pressing plate, the pressing base, and the tray to have a function of the electrode terminal plate as eliminating the arrangement of the electrode terminal plates. In this case, the pressing plate, the pressing base, and the tray may be connected to connection terminals of the cell tester.

### DESCRIPTION OF REFERENCES

51 Cell supplying unit
52 Cell folding unit
53 Electrode terminal supplying unit
54 Testing unit
55 Electrode-terminal-supplying/folding unit
100, 100A, 100B Testing device
122, 122A Sheet folding mechanism portion
106, 116 Cell tester
107 Pressing portion
108 Pressing plate
109 Pressing base
1, 1A, 10, 10A Sheet-shaped cell
21 Positive electrode terminal plate
22 Negative electrode terminal plate
211c Insulation layer
212a First conductive portion
212b Second conductive portion

## Claims

1. A testing device for a sheet-shaped cell, comprising:
a folding unit that folds a sheet-shaped cell having electrode layers on both faces while alternately changing a folding direction; and
a testing unit that performs a predetermined test as supplying power to electrode terminals in a state that the electrode terminals are inserted respectively to folded portions of the sheet-shaped cell.

2. The testing device for a sheet-shaped cell according to claim 1,
wherein the electrode terminal inserted to the folded portion of the sheet-shaped cell has conductive portions on both faces, the conductive portions being insulated to each other.

3. The testing device for a sheet-shaped cell according to claim 1 or claim 2,
wherein the testing unit measures electrical characteristics of the sheet-shaped cell sandwiched by the electrode terminals and specifies a sheet-shaped cell segment between the electrode terminals where abnormality is detected.

4. The testing device for a sheet-shaped cell according to any one of claims 1 to 3,
wherein the testing unit includes means that applies pressure to the folded sheet-shaped cell, from both faces thereof, with the electrode terminal inserted thereto.

5. The testing device for a sheet-shaped cell according to any one of claims 1 to 4, further comprising an electrode terminal supplying unit that inserts the electrode terminal to the folded portion of the sheet-shaped cell folded by the folding unit.

6. The testing device for a sheet-shaped cell according to any one of claims 1 to 4,
wherein the folding unit folds the sheet-shaped cell in a state that an electrode terminal is arranged on a surface of the sheet-shaped cell.

7. The testing device for a sheet-shaped cell according to any one of claims 1 to 6,
wherein the electrode layers of the sheet-shaped cell are discontinuously formed, and
the sheet-shaped cell is folded by the folding unit at a section where any of the electrode layers is not formed.

8. A testing method for a sheet-shaped cell, comprising steps of:
folding to fold a sheet-shaped cell having electrode layers on both faces while alternately changing a folding direction; and
testing to perform a predetermined test as supplying power to electrode terminals in a state that the electrode terminals are inserted respectively to folded portions of the sheet-shaped cell.

9. The testing method for a sheet-shaped cell according to claim 8,
wherein the electrode terminal inserted to the folded portion of the sheet-shaped cell has conductive portions on both faces, the conductive portions being insulated to each other.

10. The testing method for a sheet-shaped cell according to claim 8 or claim 9,
wherein the testing step includes measuring electrical characteristics of the sheet-shaped cell sandwiched by the electrode terminals and specifying a sheet-shaped cell segment between the electrode terminals where abnormality is detected.

11. The testing method for a sheet-shaped cell according to any one of claims 8 to 10,
wherein the test in the testing step is performed in a state that pressure is applied to the folded sheet-shaped cell, from both faces thereof, with the electrode terminal inserted thereto.

12. The testing method for a sheet-shaped cell according to any one of claims 8 to 11, further comprising an electrode terminal supplying step to insert the electrode terminal to the folded portion of the sheet-shaped cell folded in the folding step.

13. The testing method for a sheet-shaped cell according to any one of claims 8 to 11,
wherein the sheet-shaped cell is folded in the folding step in a state that an electrode terminal is arranged on a surface of the sheet-shaped cell.

14. The testing method for a sheet-shaped cell according to any one of claims 8 to 13,
wherein the electrode layers of the sheet-shaped cell are discontinuously formed, and
the sheet-shaped cell is folded in the folding step at a section where any of the electrode layers is not formed.

## Patentansprüche

1. Testvorrichtung für eine folienförmige Zelle, umfassend:
eine Falzeinheit, die eine folienförmige Zelle mit Elektrodenschichten auf beiden Außenflächen falzt, während eine Falzrichtung abwechselnd geändert wird; und
eine Testeinheit, die einen vorgegebenen Test wie das Zuführen von Leistung an Elektrodenanschlüsse in einem Zustand durchführt, bei dem die Elektrodenanschlüsse jeweils in gefalzte Teile der folienförmigen Zelle eingesetzt werden.

2. Testvorrichtung für eine folienförmige Zelle nach Anspruch 1,
wobei der in den gefalzten Teil der folienförmigen Zelle eingesetzte Elektrodenanschluss leitfähige Teile auf beiden Außenflächen aufweist, wobei die leitfähigen Teile zueinander isoliert sind.

3. Testvorrichtung für eine folienförmige Zelle nach Anspruch 1 oder Anspruch 2,
wobei die Testeinheit elektrische Eigenschaften der folienförmigen Zelle, die durch die Elektrodenanschlüsse zwischengelegt ist, misst; und ein folienförmiges Zellensegment zwischen den Elektrodenanschlüssen bestimmt, wo Abnormität festgestellt wird.

4. Testvorrichtung für eine folienförmige Zelle nach einem der Ansprüche 1 bis 3,
wobei die Testeinheit Einrichtungen enthält, die auf die gefalzte, folienförmige Zelle Druck von deren beiden Außenflächen mit dem darin eingesetzten Elektrodenanschluss aufbringt.

5. Testvorrichtung für eine folienförmige Zelle nach einem der Ansprüche 1 bis 4, des Weiteren umfassend eine den Elektrodenanschluss versorgende Einheit, die den Elektrodenanschluss in den gefalzten Teil der durch die Falzeinheit gefalzten, folienförmigen Zelle einsetzt.

6. Testvorrichtung für eine folienförmige Zelle nach einem der Ansprüche 1 bis 4,
wobei die Falzeinheit die folienförmige Zelle in einem Zustand falzt, bei dem ein Elektrodenanschluss auf einer Oberfläche der folienförmigen Zelle angeordnet ist.

7. Testvorrichtung für eine folienförmige Zelle nach einem der Ansprüche 1 bis 6,
wobei die Elektrodenschichten der folienförmigen Zelle unregelmäßig ausgebildet sind, und
die folienförmige Zelle durch die Falzeinheit an einem Querschnitt gefalzt wird, wo keine der Elektrodenschichten ausgebildet ist.

8. Testverfahren für eine folienförmige Zelle mit folgenden Schritten:
Falzen, um eine folienförmige Zelle, die Elektrodenschichten auf beiden Außenflächen aufweist, zu falzen, während eine Falzrichtung abwechselnd geändert wird; und
Testen, um einen vorgegebenen Test wie das Zuführen von Leistung an Elektrodenanschlüsse in einem Zustand durchzuführen, bei dem die Elektrodenanschlüsse jeweils in gefalzte Teile der folienförmigen Zelle eingesetzt werden.

9. Testverfahren für eine folienförmige Zelle nach Anspruch 8,
wobei der in den gefalzten Teil der folienförmigen Zelle eingesetzte Elektrodenanschluss leitfähige Teile auf beiden Außenflächen aufweist, wobei die leitfähigen Teile zueinander isoliert sind.

10. Testverfahren für eine folienförmige Zelle nach Anspruch 8 oder Anspruch 9,
wobei der Testschritt das Messen von elektrischen Eigenschaften der folienförmigen Zelle, die zwischen den Elektrodenanschlüssen eingelegt ist, und das Festlegen eines folienförmigen Zellensegments zwischen den Elektrodenanschlüssen, wo Abnormität festgestellt wird, umfasst.

11. Testverfahren für eine folienförmige Zelle nach einem der Ansprüche 8 bis 10,
wobei der Test im Testschritt in einem Zustand durchgeführt wird, wo auf die gefalzte, folienförmige Zelle Druck von deren beiden Außenflächen mit dem darin eingesetzten Elektrodenanschluss aufgebracht wird.

12. Testverfahren für eine folienförmige Zelle nach einem der Ansprüche 8 bis 11, des Weiteren umfassend einen Elektrodenanschluss-Zuführschritt zum Einsetzen des Elektrodenanschlusses in den gefalzten Teil der im Falzschritt gefalzten, folienförmigen Zelle.

13. Testverfahren für eine folienförmige Zelle nach einem der Ansprüche 8 bis 11,
wobei die folienförmige Zelle im Falzschritt in einem Zustand gefalzt wird, bei dem ein Elektrodenanschluss auf einer Oberfläche der folienförmigen Zelle angeordnet ist.

14. Testverfahren für eine folienförmige Zelle nach einem der Ansprüche 8 bis 13,
wobei die Elektrodenschichten der folienförmigen Zelle unregelmäßig ausgebildet sind, und
die folienförmige Zelle im Falzschritt an einem Querschnitt gefalzt wird, wo keine der Elektrodenschichten ausgebildet ist.

## Revendications

1. Dispositif de test destiné à une pile en forme de feuille, comprenant :
une unité de pliage qui plie une pile en forme de feuille présentant des couches d'électrode sur les deux faces tout en changeant de manière alternée un sens de pliage ; et
une unité de test qui exécute un test prédéterminé en alimentant de l'énergie aux bornes d'électrode dans un état dans lequel les bornes d'électrode sont insérées de manière respective aux niveau des parties pliées de la pile en forme de feuille.

2. Dispositif de test destiné à une pile en forme de feuille selon la revendication 1,
la borne d'électrode insérée au niveau de la partie pliée de la pile en forme de feuille présentant des parties conductrices sur les deux faces, les parties conductrices étant isolées les unes des autres.

3. Dispositif de test destiné à une pile en forme de feuille selon la revendication 1 ou la revendication 2,
dans lequel l'unité de test mesure les caractéristiques électriques de la pile en forme de feuille prise en sandwich par les bornes d'électrode et spécifie un segment de pile en forme de feuille entre les bornes d'électrode où l'anomalie est détectée.

4. Dispositif de test destiné à une pile en forme de feuille selon l'une quelconque des revendications 1 à 3,
dans lequel l'unité de test comprend un moyen qui applique une pression à la pile en forme de feuille pliée, à partir de ses deux faces, avec la borne d'électrode insérée à cet endroit.

5. Dispositif de test destiné à une pile en forme de feuille selon l'une quelconque des revendications 1 à 4, comprenant en outre une unité d'alimentation de borne d'électrode qui insère la borne d'électrode au niveau de la partie pliée de la pile en forme de feuille pliée par l'unité de pliage.

6. Dispositif de test destiné à une pile en forme de feuille selon l'une quelconque des revendications 1 à 4,
dans lequel l'unité de pliage plie la pile en forme de feuille sous un état dans lequel une borne d'électrode est disposée sur une surface de la pile en forme de feuille.

7. Dispositif de test destiné à une pile en forme de feuille selon l'une quelconque des revendications 1 à 6,
dans lequel les couches d'électrode de la pile en forme de feuille sont formées de manière discontinue, et
la pile en forme de feuille est pliée par l'unité de pliage au niveau d'une section où n'importe laquelle des couches d'électrode n'est pas formée.

8. Procédé de test destiné à une pile en forme de feuille, comprenant les étapes de :
pliage pour plier une pile en forme de feuille présentant des couches d'électrode sur les deux faces tout en changeant de manière alternée un sens de pliage ; et
test pour exécuter un test prédéterminé tel que l'alimentation d'énergie aux bornes d'électrode sous un état dans lequel les bornes d'électrode sont insérées respectivement au niveau des parties pliées de la pile en forme de feuille.

9. Procédé de test destiné à une pile en forme de feuille selon la revendication 8,
dans lequel la borne d'électrode insérée au niveau de la partie pliée de la pile en forme de feuille présente des parties conductrices sur les deux faces, les parties conductrices étant isolées les unes des autres.

10. Procédé de test destiné à une pile en forme de feuille selon la revendication 8 ou la revendication 9,
dans lequel l'étape de test comprend la mesure des caractéristiques électriques de la pile en forme de feuille prise en sandwich par les bornes d'électrode et décrit un segment de pile en forme de feuille entre les bornes d'électrode où l'anomalie est détectée.

11. Procédé de test destiné à une pile en forme de feuille selon l'une quelconque des revendications 8 à 10,
dans lequel le test dans l'étape de test est exécuté dans un état dans lequel une pression est appliquée à la pile en forme de feuille pliée, à partir de ses deux faces, avec la borne d'électrode insérée à cet endroit.

12. Procédé de test destiné à une pile en forme de feuille selon l'une quelconque des revendications 8 à 11, comprenant en outre une étape d'alimentation de borne d'électrode pour insérer la borne d'électrode au niveau de la partie pliée de la pile en forme de feuille pliée dans l'étape de pliage.

13. Procédé de test destiné à une pile en forme de feuille selon l'une quelconque des revendications 8 à 11,
dans lequel la pile en forme de feuille est pliée dans l'étape de pliage sous un état dans lequel une borne d'électrode est disposée sur une surface de la pile en forme de feuille.

14. Procédé de test destiné à une pile en forme de feuille selon l'une quelconque des revendications 8 à 13,
dans lequel les couches d'électrode de la pile en forme de feuille sont formées de manière discontinue, et
la pile en forme de feuille est pliée dans l'étape de pliage au niveau d'une section où n'importe laquelle des couches d'électrode n'est pas formée.
